# EUROPÄISCHE PATENTSCHRIFT

(11) **EP 0 924 766 B1**
(45) Veröffentlichungstag und Bekanntmachung des Hinweises auf die Patenterteilung: **20.02.2008**
(21) Anmeldenummer: 98120336.7
(22) Anmeldetag: 27.10.1998
(51) Int. Cl.: H01L 27/108, H01L 27/115, G11C 11/408

(54) **Speicherzellenanordnung und Verfahren zu deren Herstellung**
Memory cell array and method of its manufacture
Réseau de cellules de mémoire et procédé de fabrication

(30) Priorität: 17.12.1997 DE 19756183
(43) Veröffentlichungstag der Anmeldung: 23.06.1999
(73) Patentinhaber: Qimonda AG, 81739 München (DE)
(72) Erfinder: Hofmann, Franz, Dr., 80995 München (DE); Rösner, Wolfgang, Dr., 81739 München (DE); Schlösser, Till, Dr., 80339 München (DE); Krautschneider, Wolfgang, 83104 Hohenthann (DE); Risch, Lothar, Dr., 85579 Neubiberg (DE); Basse, Paul-Werner, von, 82515 Wolfratshausen (DE)
(74) Vertreter: Barth, Stephan Manuel

(56) Entgegenhaltungen:
- DE-A- 4 312 651
- DE-C- 19 519 160
- US-A- 4 168 538
- PATENT ABSTRACTS OF JAPAN vol. 014, no. 463 (E-0988), 8. Oktober 1990 (1990-10-08) & JP 02 188958 A (MITSUBISHI ELECTRIC CORP), 25. Juli 1990 (1990-07-25)

## Beschreibung

Speicherzellenanordnungen, insbesondere DRAM-Anordnungen, ROM-Anordnungen, EPROM-Anordnungen und EEPROM-Anordnungen, weisen eine Vielzahl von Speicherzellen auf, die meist matrixförmig angeordnet sind. Die einzelnen Speicherzellen sind dabei jeweils über eine Bitleitung und eine Wortleitung ansteuerbar. Die Speicherzellen weisen jeweils ein Speicherelement auf, in dem Information gespeichert ist. Die Speicherung der Information erfolgt zum Beispiel über eine in einer Speicherkapazität gespeicherte Ladung, über eine auf einem floatenden Gate gespeicherte Ladung, oder über Eigenschaften eines Transistors, zum Beispiel der Einsatzspannung, oder über das Vorhandensein bzw. Nichtvorhandensein einer leitenden Verbindung zur Bitleitung.

Zum Auslesen der Information werden die einzelnen Speicherzellen sequentiell über die zugehörige Wortleitung und Bitleitung angesteuert und die Information durch Spannungs- oder Strombewertung ausgelesen (siehe zum Beispiel Y. Nakagome et al, IEEE Journal of Solid-State Circuits, Vol. 26, Nr. 4, 1991, Seiten 465 bis 470). Die Strombewertung ist bezüglich der Lesegeschwindigkeit der Spannungsbewertung vorzuziehen, sie erfordert jedoch einen erhöhten Schaltungsaufwand. Zur Beschleunigung des Lesevorgangs werden vielfach mehrere, zum Beispiel 256 Speicherzellen zu einem Zellenblock zusammengefaßt. Die einzelnen Zellenblöcke werden dann parallel ausgelesen. Der Auslesevorgang in dem einzelnen Zellenblock erfolgt jedoch nach wie vor sequentiell.

In elektrisch beschreibbaren Speicherzellenanordnungen, zum Beispiel DRAM-Anordnungen oder EEPROM-Anordnungen, wird zum Einschreiben von Information die jeweilige Speicherzelle ebenfalls über die zugehörige Bitleitung und die Wortleitung angesteuert. Gleichzeitig wird die Bitleitung mit einem Spannungspegel beaufschlagt, der der einzuschreibenden Information entspricht. Das Einschreiben der Information erfolgt sequentiell in alle Speicherzellen. Dabei muß die Bitleitung jedesmal von einem Spannungszustand zum anderen Spannungszustand umgeladen werden. Dieses ist mit einem Verbrauch elektrischer Leistung verbunden, der insbesondere beim Einsatz der Speicherzellenanordnung in mobilen Geräten wie zum Beispiel Mobiltelefone, Notebook-Computer, Datenbankrechner oder PDA (Personal Digital Assistant) als störend empfunden wird.

Bei DRAM-Anordnungen tritt darüber hinaus das Problem auf, daß die gespeicherte Information in regelmäßigen Zeitabständen wieder aufgefrischt werden muß. Dazu wird die Information zunächst sequentiell aus den Speicherzellen ausgelesen und anschließend wieder eingeschrieben. Auch hier tritt unerwünschter Leistungsverbrauch auf.

Ein weiteres Problem bei DRAM-Anordnungen stellt die von Speichergeneration zu Speichergeneration zunehmende Speicherdichte dar. Damit verbunden ist das Erfordernis einer erhöhten Packungsdichte, das heißt einer Verringerung des Platzbedarfs pro Speicherzelle. Aus DE 19 519 160 C1 ist eine DRAM-Zellenanordnung bekannt, die mit einer Speicherzellenfläche von 4F² herstellbar ist, wobei F die in der jeweiligen Technologie minimal herstellbare Strukturgröße ist. Pro Speicherzelle ist dabei ein vertikaler MOS-Transistor vorgesehen, dessen erstes Source-/Drain-Gebiet mit einem Speicherknoten eines Speicherkondensators verbunden ist, dessen Kanalgebiet ringförmig von einer Gateelektrode umschlossen wird und dessen zweites Source-/Drain-Gebiet mit einer vergrabenen Bitleitung verbunden ist. Die Gateelektroden von entlang einer Wortleitung benachbarten vertikalen MOS-Transistoren grenzen dabei aneinander und bilden gemeinsam die Wortleitung.

Die US 4,168,538 offenbart einen monolithischen Halbleiterspeicher mit mehreren Speicherelementen, die jeweils einen Speicherkondensator und zwei Auswahltransistoren aufweisen.

Der Erfindung liegt das Problem zugrunde, eine Speicherzellenanordnung anzugeben, die auf verbesserte Weise ansteuerbar ist. Insbesondere soll die Speicherzellenanordnung mit einer Speicherdichte herstellbar sein, wie sie in den Giga-Bit-Generationen erforderlich ist. Ferner soll ein Herstellverfahren für eine solche Speicherzellenanordnung angegeben werden.

Dieses Problem wird gelöst durch eine Speicherzellenanordnung gemäß Anspruch 1 und ein Verfahren zu deren Herstellung gemäß Anspruch 9. Weitere Ausgestaltungen der Erfindung gehen aus den abhängigen Ansprüchen hervor.

Es ist ein Halbleitersubstrat mit einer Vielzahl Speicherzellen vorgesehen. Die Speicherzellen weisen jeweils mindestens einen in Bezug auf eine Hauptfläche des Halbleitersubstrats vertikalen Auswahltransistor auf, der mit einem Speicherelement verbunden ist. Vorzugsweise ist der Auswahltransistor zwischen eine Bitleitung und das Speicherelement geschaltet. Die Bitleitungen können jedoch auch anders verschaltet sein. Die Speicherzellen sind jeweils über eine erste Wortleitung und eine zweite Wortleitung ansteuerbar, wobei sich die erste Wortleitung und die zweite Wortleitung kreuzen. Die Ansteuerung einer Speicherzelle erfolgt nur über die erste Wortleitung und die zweite Wortleitung. Dadurch können Bitleitungen parallel ausgelesen werden.

Im Fall einer elektrisch beschreibbaren Speicherzellenanordnung werden die Speicherzellen ebenfalls jeweils über die erste Wortleitung und die zweite Wortleitung angesteuert. Die Bitleitung wird nur zum Anlegen des der Information entsprechenden Spannungspegels und nicht zur Ansteuerung verwendet. Daher können zum Einschreiben einer einem vorgegebenen Spannungspegel entsprechenden Information alle Bitleitungen mit dem vorgegebenen Spannungspegel beaufschlagt werden. Über die ersten Wortleitungen und die zweiten Wortleitungen werden diejenigen Speicherzellen angesteuert, in denen die zugehörige Information gespeichert werden soll. Diese wird in einem Takt in alle entsprechenden Speicherzellen eingeschrieben. Zum Einschreiben einer digitalen Information sind daher zwei Vorgänge ausreichend: erstens paralleles Einschreiben einer "Eins" und zweitens paralleles Einschreiben einer "Null". Dadurch beschleunigt sich der Schreibvorgang erheblich im Vergleich zum Stand der Technik. Darüber hinaus muß die Bitleitung nur so oft umgeladen werden, wie es der Anzahl der unterschiedlichen Informationen entspricht. Im Fall einer digitalen Information muß die Bitleitung nur zweimal umgeladen werden. Dadurch wird der Leistungsverbrauch reduziert.

Im Fall einer DRAM-Anordnung wird dieses auch für das Auffrischen der Information (refresh) ausgenutzt. Vorzugsweise wird dabei die gespeicherte Information über ein Schieberegister ausgelesen. Das im Schieberegister gespeicherte Datenwort wird nachfolgend zur Ansteuerung der ersten Wortleitungen und der zweiten Wortleitungen verwendet, wobei die Bitleitung auf die jeweiligen Spannungspegel gelegt wird.

Bedingt durch die im Vergleich zum Stand der Technik wesentlich geringere Anzahl von erforderlichen Umladevorgängen der Bitleitung wird der Leistungsverbrauch beim Einschreiben sowie beim Auffrischen von Information deutlich verringert.

Als Halbleitersubstrat ist insbesondere eine monokristalline Siliziumscheibe oder die monokristalline Siliziumschicht eines SOI-Substrats geeignet.

Als Speicherelement sind alle in Speicherzellenanordnungen üblicherweise verwendeten Speicherelemente geeignet. Insbesondere sind Speicherelemente geeignet, die MOS-Transistoren mit unterschiedlichen elektrischen Eigenschaften aufweisen, wie sie vielfach in ROM-Anordnungen verwendet werden, Leitungsunterbrechungen, wie sie in ROM-Anordnungen verwendet werden, Schmelzsicherungen (sogenannten fuses), MOS-Transistoren mit floatendem Gate sowie Speicherkapazitäten geeignet.

Es liegt im Rahmen der Erfindung, die Speicherzellenanordnung als DRAM-Anordnung auszugestalten. In diesem Fall ist sowohl der Vorteil des schnelleren Datenzugriffs beim Lesen und Schreiben von Information als auch der Vorteil des geringeren Leistungsverbrauchs beim Schreiben und Auffrischen der Information nutzbar. In der DRAM-Anordnung ist das Speicherelement vorzugsweise als Speicherkapazität ausgestaltet, die sowohl im Halbleitersubstrat, insbesondere als Grabenkondensator, als auch an der Hauptfläche des Halbleitersubstrats bzw. oberhalb der Hauptfläche des Halbleitersubstrats, insbesondere als Stapelkondensator, realisiert sein kann. Als Kondensatordielektrikum sind die üblichen Speicherdielektrika geeignet, insbesondere Siliziumoxid, Kombinationen aus Siliziumoxid und Siliziumnitrid oder Hochepsilon-Dielektrika wie zum Beispiel BST (Barium-Strontium-Titanat), Ta₂O₅ oder SBT (Strontium-Wismuth-Tantalat).

Gemäß einer Ausgestaltung der Erfindung werden mehrere der Speicherzellen zu einem Zellenblock zusammengefaßt. Die Speicherzellen jedes Zellenblocks sind mit einer gemeinsamen Bitleitung verbunden. Dieses hat den Vorteil, daß der Bitleitungswiderstand reduziert wird. Ferner ergeben sich dadurch neue Freiheiten für das Design des Leseverstärkers.

Es ist Teil der Erfindung, daß die Speicherzellen jeweils einen ersten Auswahltransistor und einen zweiten Auswahltransistor aufweisen, die in Reihe zwischen die Bitleitung und das Speicherelement geschaltet sind. Dabei ist der erste Auswahltransistor von der ersten Wortleitung und der zweite Auswahltransistor von der zweiten Wortleitung ansteuerbar. Dabei weisen im Hinblick auf eine erhöhte Packungsdichte benachbarte Speicherzellen jeweils einen gemeinsamen ersten Auswahltransistor und eine gemeinsame erste Wortleitung auf. Die benachbarten Speicherzellen weisen unterschiedliche zweite Auswahltransistoren und unterschiedliche zweite Wortleitungen auf. Sie sind jeweils über die gemeinsame erste Wortleitung und die unterschiedlichen zweiten Wortleitungen ansteuerbar.

Gemäß einer Ausgestaltung der Erfindung sind die zwei benachbarten Speicherzellen mit einem gemeinsamen ersten Auswahltransistor und unterschiedlichen zweiten Auswahltransistoren in einer Halbleitersäule angeordnet. Die Halbleitersäule grenzt an die Hauptfläche des Halbleitersubstrats an und weist Flanken auf, die die Hauptfläche des Halbleitersubstrats kreuzen. Sie wird insbesondere durch im wesentlichen parallel verlaufende erste Gräben und im wesentlich parallel verlaufende zweite Gräben, die einander kreuzen, definiert. Der gemeinsame erste Auswahltransistor ist als vertikaler MOS-Transistor ausgebildet, dessen Gateelektrode an mindestens einer Flanke der Halbleitersäule angeordnet ist. Im Bereich der Hauptfläche sind die zweiten Auswahltransistoren der beiden benachbarten Speicherzellen als planare MOS-Transistoren angeordnet. Die Gateelektroden der zweiten Auswahltransistoren befinden sich jeweils oberhalb der Hauptfläche der Halbleitersäule. Sie sind Bestandteil der unterschiedlichen zweiten Wortleitungen. Die Gateelektrode des gemeinsamen ersten Auswahltransistors ist Bestandteil der ersten Wortleitung. Die benachbarten Speicherzellen sind in einer Halbleitersäule angeordnet.

In dieser Ausgestaltung der Erfindung ist es vorteilhaft, die erste Gateelektrode des gemeinsamen ersten Auswahltransistors ringförmig auszubilden, so daß diese die Halbleitersäule umgibt. Werden die Halbleitersäulen von entlang einer der ersten Wortleitungen benachbarten Speicherzellenpaaren so angeordnet, daß ihr Abstand geringer ist als die Dicke der ersten Gateelektroden parallel zur Hauptfläche, so grenzen die ersten Gateelektroden benachbarter Halbleitersäulen aneinander an und bilden auf diese Weise die erste Wortleitung. Quer zur ersten Wortleitung ist der Abstand benachbarter Halbleitersäulen größer als die doppelte Dicke der ersten Gateelektroden parallel zur Hauptfläche. Die erste Wortleitung läßt sich in diesem Fall durch selbstjustierende Prozeßschritte, das heißt ohne Einsatz von zu justierenden Masken herstellen.

Es liegt ferner im Rahmen der Erfindung, den ersten Auswahltransistor und den zweiten Auswahltransistor jeweils entlang mindestens einer Flanke einer Halbleitersäule anzuordnen, die an die Hauptfläche des Halbleitersubstrats angrenzt und die die Hauptfläche kreuzende Flanken aufweist. Der erste Auswahltransistor und der zweite Auswahltransistor sind dabei übereinander angeordnet. Eine erste Gateelektrode des ersten Auswahltransistors und eine zweite Gateelektrode des zweiten Auswahltransistors grenzen dabei an die jeweilige Flanke der Halbleitersäule an.

Es liegt im Rahmen der Erfindung, daß in dieser Ausgestaltung die erste Gateelektrode und die zweite Gateelektrode die Halbleitersäule jeweils ringförmig umgibt. Vorzugsweise wird diese Ausgestaltung dadurch hergestellt, daß in der Hauptfläche des Halbleitersubstrats erste Gräben und zweite Gräben geätzt werden. Die ersten Gräben verlaufen untereinander jeweils im wesentlichen parallel. Die zweiten Gräben verlaufen untereinander ebenfalls im wesentlichen parallel. Die ersten Gräben und die zweiten Gräben kreuzen einander. Je zwei benachbarte erste Gräben und zweite Gräben definieren dabei eine der Halbleitersäulen. Vor der Herstellung der ersten Gateelektroden wird der Querschnitt der Halbleitersäulen durch mindestens eine Hilfsstruktur vergrößert, so daß der Abstand benachbarter Halbleitersäulen in Richtung der ersten Wortleitungen geringer als in Richtung der zweiten Wortleitungen ist. Im Bereich der zweiten Wortleitungen wird mit Hilfe mindestens einer zweiten Hilfsstruktur der Querschnitt der Halbleitersäulen so vergrößert, daß im Bereich der zweiten Wortleitungen der Abstand zwischen benachbarten Halbleitersäulen in Richtung der zweiten Wortleitungen geringer ist als in Richtung der ersten Wortleitungen. Die ersten Wortleitungen und die zweiten Wortleitungen werden dann selbstjustiert zum Beispiel durch Abscheidung einer Schicht und anisotropes Rückätzen der Schicht im Sinne einer Spacerbildung hergestellt. Da der Abstand benachbarter Halbleitersäulen in der einen Richtung geringer als in der anderen Richtung ist, grenzen benachbarte Gateelektroden in der Richtung mit geringerem Abstand aneinander an, während sie in der Richtung mit dem größeren Abstand voneinander beabstandet sind. Auf diese Weise entstehen kettenartige Leitungen, die parallel zueinander verlaufen. In dieser Ausgestaltung weist jede Halbleitersäule eine Speicherzelle auf.

Die Halbleitersäulen können sowohl durch Ätzen der Gräben in einem Halbleitersubstrat als auch durch selektive Epitaxie innerhalb von Öffnungen einer gitterförmigen Isolationsstruktur gebildet werden. Die gitterförmige Isolationsstruktur definiert im zweiten Fall den Verlauf der Gräben.

Da jede Speicherzelle über die erste und die zweite Wortleitung ansteuerbar ist, läßt sich die Speicherzellenanordnung durch entsprechende Ansteuerung der ersten und zweiten Wortleitungen im Sinne einer Folded-Bitline-Architektur betreiben.

Im folgenden werden Ausführungsbeispiele der Erfindung, die in den Figuren dargestellt sind, näher erläutert.
- Figur 1: zeigt einen Schnitt durch ein Halbleitersubstrat mit einer ersten Grabenmaske.
- Figur 2: zeigt den Schnitt durch das Halbleitersubstrat nach einer ersten Grabenätzung.
- Figur 3: zeigt den Schnitt durch das Halbleitersubstrat nach Bildung einer zweiten Grabenmaske.
- Figur 4: zeigt den in Figur 3 mit IV-IV bezeichneten Schnitt. Der in Figur 3 gezeichnete Schnitt ist in Figur 4 mit III-III bezeichnet.
- Figur 5: zeigt den in Figur 4 dargestellten Schnitt nach einer zweiten Grabenätzung.
- Figur 6: zeigt den in Figur 3 dargestellten Schnitt nach Bildung einer ersten dielektrischen Schicht und einer ersten leitfähigen Schicht.
- Figur 7: zeigt den in Figur 6 mit VII-VII bezeichneten Schnitt. Der in Figur 6 dargestellte Schnitt ist in Figur 7 mit VI-VI bezeichnet.
- Figur 8: zeigt den in Figur 6 dargestellten Schnitt durch das Halbleitersubstrat nach Bildung erster Wortleitungen, einer zweiten dielektrischen Schicht und zweiter Wortleitungen.
- Figur 9: zeigt den in Figur 8 mit IX-IX bezeichneten Schnitt. In Figur 9 ist der in Figur 8 dargestellte Schnitt mit VIII-VIII bezeichnet.
- Figur 10: zeigt den in Figur 8 dargestellten Schnitt nach Bildung von ersten n⁺-dotierten Gebieten und zweiten n⁺- dotierten Gebieten sowie nach Abscheidung einer Zwischenoxidschicht, Öffnung von Kontakten, nach Bildung eines Kondensatordielektrikums und einer Kondensatorplatte.
- Figur 11: zeigt den in Figur 10 mit XI-XI bezeichneten Schnitt. In Figur 11 ist der in Figur 10 dargestellte Schnitt mit X-X bezeichnet.
- Figur 12: zeigt den in Figur 10 und Figur 11 mit XII-XII bezeichneten Schnitt. Die in Figur 10 und Figur 11 dargestellten Schnitte sind mit X-X bzw. XI-XI bezeichnet.
- Figur 13: zeigt einen Schnitt durch ein Halbleitersubstrat nach Bildung erster Gräben.
- Figur 14: zeigt den in Figur 13 dargestellten Schnitt durch das Halbleitersubstrat nach Bildung von Nitridspacern an den Flanken der ersten Gräben und Auffüllen der ersten Gräben mit einer SiO₂-Struktur.
- Figur 15: zeigt den in Figur 14 mit XV-XV bezeichneten Schnitt durch das Halbleitersubstrat nach Bildung zweiter Gräben. Der in Figur 14 dargestellte Schnitt ist mit XIV-XIV bezeichnet.
- Figur 16: zeigt den in Figur 14 gezeigten Schnitt durch das Halbleitersubstrat nach Bildung eines ersten Gatedielektrikums und erster Wortleitungen, die mit einer zweiten Isolationsstruktur bedeckt sind.
- Figur 17: zeigt den in Figur 16 mit XVII-XVII bezeichneten Schnitt durch das Halbleitersubstrat. Der in Figur 16 dargestellte Schnitt durch das Halbleitersubstrat ist in Figur 17 mit XVI-XVI bezeichnet.
- Figur 18: zeigt den in Figur 16 dargestellten Schnitt nach einer selektiven Epitaxie zur Bildung einer zweiten Hilfsstruktur.
- Figur 19: zeigt den in Figur 18 mit XIX-XIX bezeichneten Schnitt. In Figur 19 ist der in Figur 18 dargestellte Schnitt mit XVIII-XVIII bezeichnet.
- Figur 20: zeigt den in Figur 18 dargestellten Schnitt nach Rückätzen der ersten Hilfsstrukturen, Bilden eines zweiten Gatedielektrikums, zweiter Wortleitungen und einer dritten Isolationsstruktur sowie nach einer Implantation.
- Figur 21: zeigt den in Figur 20 mit XXI-XXI bezeichneten Schnitt. In Figur 21 ist mit XX-XX der in Figur 20 dargestellte Schnitt eingetragen.
- Figur 22: zeigt den in Figur 20 dargestellten Schnitt nach Bildung eines Kondensatordielektrikums und einer Kondensatorplatte.
- Figur 23: zeigt den in Figur 22 mit XXIII-XXIII bezeichneten Schnitt.
- Figur 24: zeigt den in Figur 22 mit XIV-XIV bezeichneten Schnitt.
- Figur 25: zeigt eine Schaltung zum Einschreiben von Information in eine Speicherzellenanordnung mit ersten Wortleitungen und zweiten Wortleitungen.
- Figur 26: zeigt eine Schaltung zum Auslesen einer Speicherzellenanordnung mit ersten Wortleitungen und zweiten Wortleitungen und streifenförmigen, vergrabenen Bitleitungen.

Die Darstellungen in den Figuren sind nicht maßstabsgerecht.

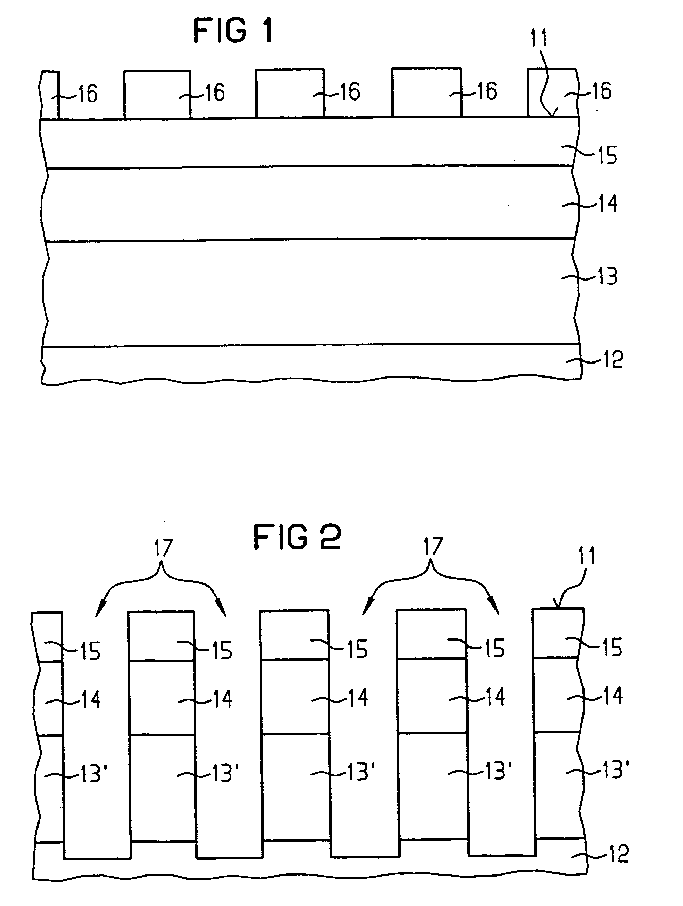

Ein Halbleitersubstrat, das mindestens im Bereich einer Hauptfläche 11 monokristallines Silizium aufweist, umfaßt einen p-dotierten Substratkörper 12, eine darauf angeordnete n⁺-dotierte Siliziumschicht 13, eine darauf angeordnete erste p-dotierte Schicht 14 und eine darauf angeordnete zweite p-dotierte Siliziumschicht 15 (siehe Figur 1). Der p-dotierte Substratkörper 12 weist eine Dotierstoffkonzentration von 10¹⁶ cm⁻³ auf. Die n⁺-dotierte Siliziumschicht 13 ist durch epitaktisches Aufwachsen in einer Dicke von 500 nm erzeugt. Sie weist eine Dotierstoffkonzentration von 10²⁰ cm⁻³ auf. Die erste p-dotierte Siliziumschicht 14 und die zweite p-dotierte Siliziumschicht 15 sind epitaktisch aufgewachsen und weisen gemeinsam eine Dicke von 500 nm auf. Die erste p-dotierte Siliziumschicht 14 weist eine Dicke von 200 nm und eine Dotierstoffkonzentration von 10¹⁷ cm⁻³ auf. Die zweite p-dotierte Siliziumschicht 15 weist eine Dicke von 300 nm und eine Dotierstoffkonzentration von 10¹⁶ cm⁻³ auf.

Anschließend wird auf der Hauptfläche 11 eine erste Grabenmaske 16 durch Abscheidung und Strukturierung einer SiO₂-Schicht gebildet. Die SiO₂-Schicht wird in einem TEOS-Verfahren in einer Schichtdicke von 150 nm abgeschieden und mit Hilfe einer Photolackmaske durch Trockenätzen mit CHF₃, O₂ strukturiert. Die erste Grabenmaske 16 weist streifenförmige Öffnungen auf, die eine Breite von 250 nm und einen gegenseitigen Abstand von 250 nm haben. Die Breite und der Abstand entsprechen jeweils einer in der verwendeten Technologie minimal herstellbaren Strukturgröße F.

Nach Entfernen der Photolackmaske, die zur Bildung der ersten Grabenmaske 16 verwendet wurde, werden erste Gräben 17 geätzt, wobei die erste Grabenmaske 16 als Ätzmaske in einem Trockenätzprozeß mit HBr, He, O₂, NF₃ verwendet wird. Anschließend wird die erste Grabenmaske 16 naßchemisch zum Beispiel mit HF entfernt (siehe Figur 2). Die Tiefe der ersten Gräben 17 beträgt 1100 nm. Damit reichen die ersten Gräben 17 bis in den p-dotierten Substratkörper 12 hinein. Aus der n⁺- dotierten Siliziumschicht 13 werden dabei streifenförmige Bitleitungen 13' gebildet.

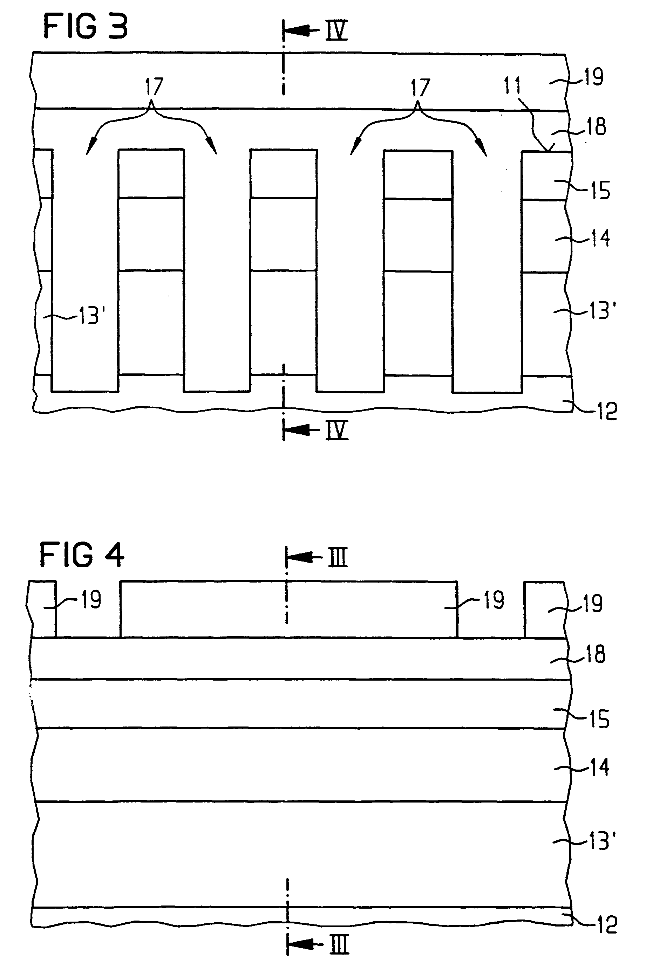

Nachfolgend wird eine SiO₂-Schicht 18 abgeschieden, die die ersten Gräben 17 vollständig auffüllt. Die SiO₂-Schicht 18 wird in einem TEOS-Verfahren in einer Schichtdicke von 200 nm abgeschieden (siehe Figur 3). Auf der Oberfläche der SiO₂-Schicht 18 wird eine Photolackmaske 19 gebildet, die streifenförmige Öffnungen aufweist. Die streifenförmigen Öffnungen der Photolackmaske 19 verlaufen quer zu den ersten Gräben 17 (siehe Figur 3 und Figur 4). Die streifenförmigen Öffnungen in der Photolackmaske 19 weisen eine Breite von 250 nm und einen gegenseitigen Abstand von 1250 nm auf.

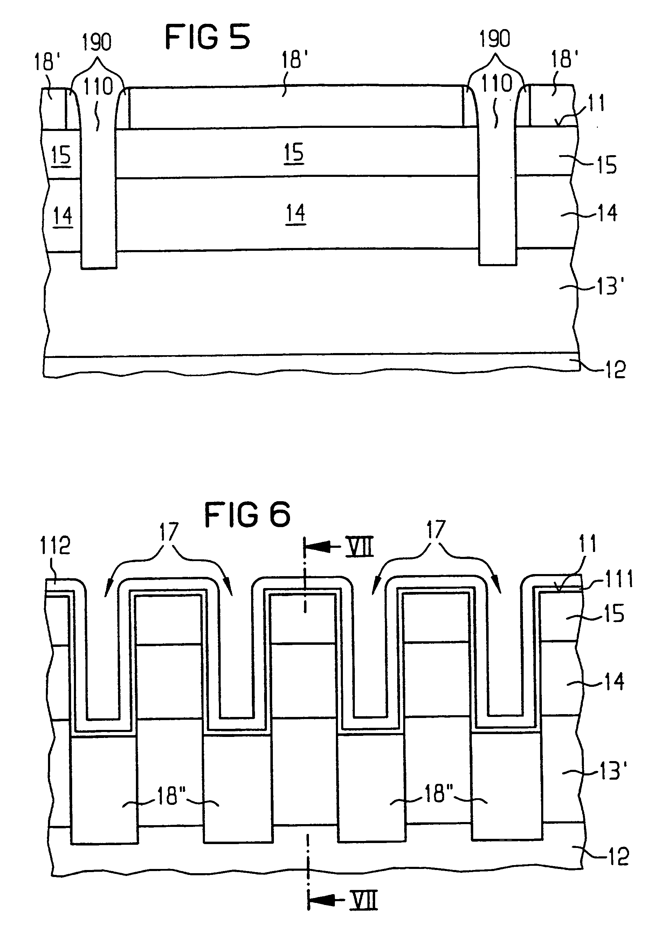

Durch Trockenätzen mit Ar, CF₄, CHF₃, N₂, He wird aus der SiO₂-Schicht 18 eine zweite Grabenmaske 18' gebildet. Nachfolgend wird die Photolackmaske 19 entfernt. Beim Strukturieren der zweiten Grabenmaske 18' bleiben die ersten Gräben 17 mit SiO₂ gefüllt. Durch Abscheiden einer SiO₂-Schicht in einem TEOS-Verfahren in einer Schichtdicke von 80 nm und anisotropes Ätzen mit CHF₃, O₂ werden an zur Hauptfläche 11 senkrechten Flanken der zweiten Grabenmaske 18' SiO₂-Spacer 19 gebildet (siehe Figur 5).

Unter Verwendung der zweiten Grabenmaske 18' und der SiO₂-Spacer 190 werden durch anisotropes Trockenätzen zweite Gräben 110 gebildet (siehe Figur 5). Die zweiten Gräben 110 werden in einer Tiefe von 500 nm geätzt. Sie reichen bis in die Bitleitungen 13' hinein, ohne die Bitleitungen 13' jedoch zu durchtrennen. Die zweiten Gräben 110 müssen so tief sein, daß die erste p-dotierte Siliziumschicht 14 sicher durchtrennt ist. Die Weite der zweiten Gräben 110 beträgt 90 nm. Sie ist im Vergleich zur Weite der streifenförmigen Öffnungen in der zweiten Grabenmaske 18' um die Breite der SiO₂-Spacer 190 reduziert.

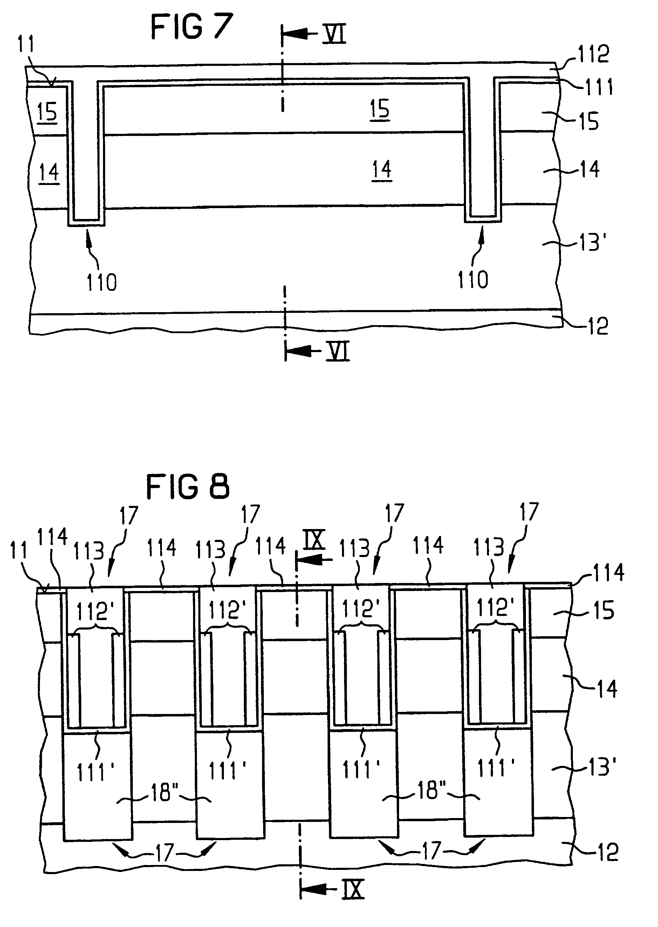

Durch anisotropes Ätzen mit CHF₃, O₂ werden anschließend die SiO₂-Spacer 190 und der obere Bereich der zweiten Grabenmaske 18' selektiv zu Silizium geätzt. Dabei wird der in den ersten Gräben 17 befindliche Teil der zweiten Grabenmaske 18' soweit geätzt, daß in den Gräben 17 erste Isolationsstrukturen 18'' aus der zweiten Grabenmaske 18' gebildet werden (siehe Figur 6 und Figur 7). Die ersten Isolationsstrukturen 18'' bedecken den Boden der ersten Gräben und reichen bis in den oberen Bereich der Bitleitungen 13'. Die Flanken der ersten p-dotierten Siliziumschicht 14, der zweiten p-dotierten Siliziumschicht 15 und im oberen Bereich der Bitleitungen 13' werden dabei freigelegt. Die Höhe der ersten Isolationsstrukturen 18'' beträgt etwa 500 nm.

Durch thermische Oxidation wird eine erste dielektrische Schicht 111 aus SiO₂ in einer Schichtdicke von 5 nm gebildet. Auf die erste dielektrische Schicht 111 wird eine leitfähige Schicht 112 aufgebracht. Die leitfähige Schicht 112 wird aus in situ dotiertem Polysilizium in einer Schichtdicke von 80 nm gebildet. Als Dotierstoff wird Phosphor verwendet. Die Dotierstoffkonzentration beträgt 10²¹ cm⁻³. Die leitfähige Schicht 112 füllt die zweiten Gräben 110 vollständig auf. Die ersten Gräben 17 werden von der leitfähigen Schicht 112 nicht aufgefüllt (siehe Figur 6 und Figur 7).

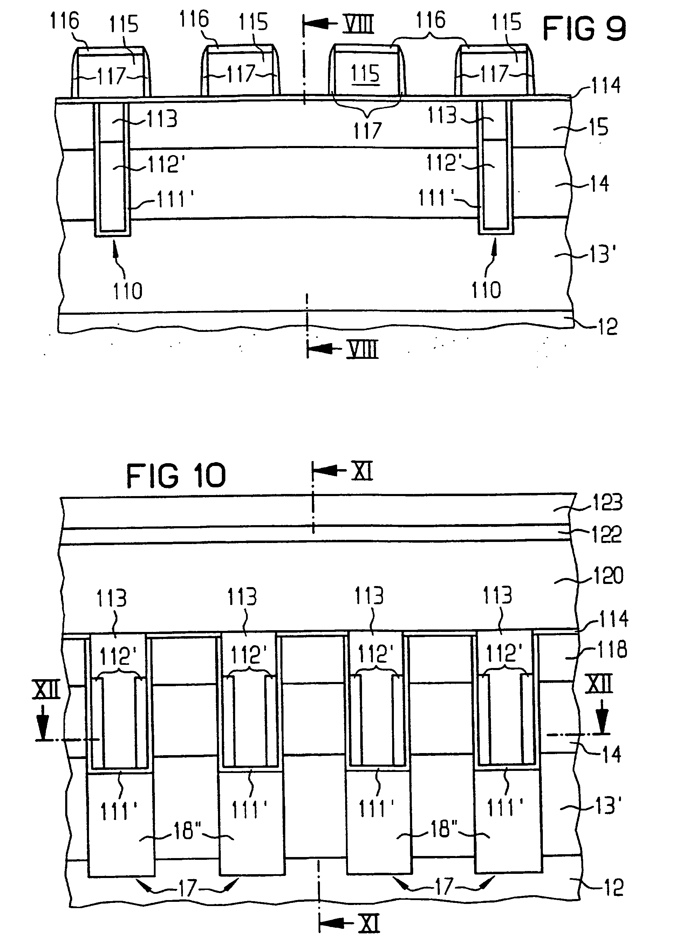

Durch anisotropes Ätzen mit He, HBr, Cl₂, C₂F₆ wird die leitfähige Schicht 112 selektiv zur ersten dielektrischen Schicht 111 geätzt. Dabei wird die leitfähige Schicht 112 bis in eine Tiefe von 200 nm unterhalb der Hauptfläche 11 entfernt. Dabei werden aus der leitfähigen Schicht 112 erste Wortleitungen 112' gebildet. Die Höhe der ersten Wortleitungen 112' wird so bemessen, daß sie den Bereich, in dem die erste dielektrische Schicht 111 die Flanken der ersten p-dotierten Siliziumschicht 14 bedeckt, sicher überdeckt. Die Wortleitung 112' wird aus ringförmigen Elementen gebildet, die jeweils eine der Halbleitersäulen umgeben. In Richtung der ersten Gräben 17 benachbarte ringförmige Elemente grenzen dabei aneinander (siehe Figur 8 und Figur 9). Durch Abscheiden und Rückätzen einer SiO₂-Schicht werden die ersten Gräben 17 und die zweiten Gräben 110 mit einer zweiten Isolationsstruktur 113 aufgefüllt. Die SiO₂-Schicht wird in einem TEOS-Verfahren in einer Schichtdicke von 200 nm abgeschieden. Das Rückätzen erfolgt mit CHF₃, O₂. Bei der Bildung der zweiten Isolationsstruktur 113 wird die Hauptfläche 11 außerhalb der ersten Gräben 17 und der zweiten Gräben 110 freigelegt.

Durch thermische Oxidation wird eine zweite dielektrische Schicht 114 aus SiO₂ in einer Schichtdicke von 5 nm gebildet. Auf der zweiten dielektrischen Schicht 114 werden streifenförmige zweite Wortleitungen 115 und darauf streifenförmige Siliziumnitridstrukturen 116 erzeugt (siehe Figur 8 und Figur 9). Die zweiten Wortleitungen 115 verlaufen parallel zu den zweiten Gräben 110. Zur Bildung der zweiten Wortleitungen werden eine zweite leitfähige Schicht und eine Siliziumnitridschicht abgeschieden und mit Hilfe einer Photolackmaske streifenförmig strukturiert. Dazu wird folgender Ätzprozeß verwendet: CF₄, O₂, N₂/ He, HBr, Cl₂, C₂F₆. Die zweiten Wortleitungen 115 werden in einer Breite von 250 nm, einem Abstand von 250 nm, einer Länge von 200 µm und einer Dicke von 150 nm gebildet. Die zweiten Wortleitungen 115 werden zum Beispiel aus in situ dotiertem Polysilizium gebildet. Als Dotierstoff ist Phosphor geeignet. Die Dotierstoffkonzentration beträgt 10²¹ cm⁻³. Die streifenförmigen Siliziumnitridstrukturen 116 weisen dieselben Abmessungen wie die zweiten Wortleitungen 115 auf und weisen eine Dicke von 50 nm auf.

Durch Abscheiden einer Siliziumnitridschicht und anisotropes Ätzen der Siliziumnitridschicht werden an den Flanken der zweiten Wortleitungen 115 Siliziumnitridspacer gebildet. Die Siliziumnitridschicht wird in einem CVD-Verfahren in einer Schichtdicke von 30 nm abgeschieden. Die Ätzung erfolgt mit CF₄, O₂, N₂. Die Ätzung erfolgt selektiv zu SiO₂.

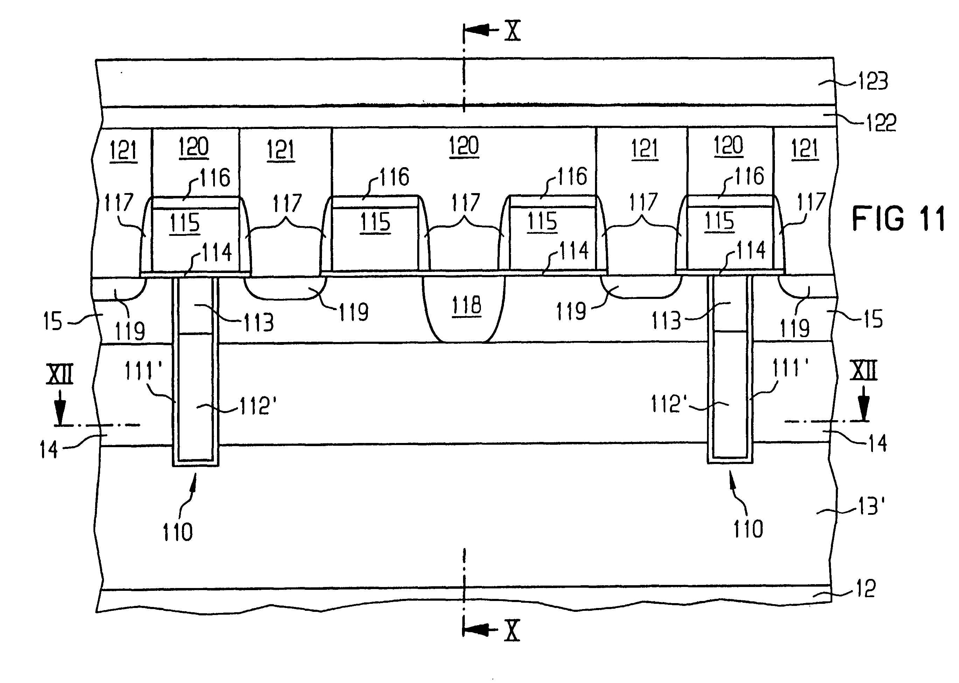

Unter Verwendung einer Photolackmaske (nicht dargestellt) als Implantationsmaske werden nachfolgend erste n⁺-dotierte Gebiete 118 gebildet. Die ersten n⁺-dotierten Gebiete 118 sind jeweils zwischen benachbarten ersten Gräben 17 angeordnet, grenzen an die Hauptfläche 11 und grenzen an die Grenzfläche zur ersten p-dotierten Siliziumschicht 14 an. In jeder Halbleitersäule, die durch jeweils benachbarte erste Gräben 17 und zweite Gräben 110 definiert wird, ist ein erstes n⁺- dotiertes Gebiet 118 vorgesehen. Es befindet sich in etwa in der Mitte zwischen benachbarten zweiten Gräben 110 (siehe Figur 10 und Figur 11). Die ersten n⁺-dotierten Gebiete 118 weisen eine Dotierstoffkonzentration von 10²¹ cm⁻³ auf und eine Tiefe von 300 nm. Die Implantation erfolgt mit Phosphor oder mit Arsen.

Nach Entfernen der Photolackmaske wird eine weitere Photolackmaske (nicht dargestellt) gebildet, die als Implantationsmaske zur Bildung zweiter n⁺-dotierter Gebiete 119 verwendet wird. In jeder Halbleitersäule werden zwei n⁺-dotierte Gebiete 119 gebildet, die beiderseits des jeweiligen ersten n⁺-dotierten Gebietes 118 zwischen benachbarten zweiten Gräben 110 angeordnet sind. Zwischen dem zweiten n⁺-dotierten Gebiet 119 und dem ersten n⁺-dotierten Gebiet 118 grenzt jeweils die zweite p-dotierte Siliziumschicht 15 an die Hauptfläche 11 an. Die Tiefe der zweiten n⁺-dotierten Gebiete 119 beträgt 100 nm. Sie ist geringer als die Dicke der zweiten dotierten Siliziumschicht 15. Die Implantation erfolgt mit Phosphor. Zwischen dem ersten n⁺-dotierten Gebiet 118 und jedem der zweiten n⁺-dotierten Gebiete 119 verläuft an der Oberfläche der Halbleitersäulen eine der zweiten Wortleitungen 115 (siehe Figur 11). Anschließend wird eine SiO₂-Schicht 120 abgeschieden und durch chemisch-mechanisches Polieren (CMP) planarisiert. Die planare Oberfläche der SiO₂-Schicht 120 ist etwa 500 nm oberhalb der Hauptfläche 11 angeordnet.

Mit einer Photolackmaske und anisotropem Ätzen zum Beispiel mit Ar, CF₄, CHF₃ werden nachfolgend Kontaktlöcher zu den zweiten n⁺-dotierten Gebieten 119 in der SiO₂-Schicht 120 geöffnet. Die Kontaktlöcher werden mit Speicherknoten 121 versehen. Dazu wird ganzflächig eine dotierte Polysiliziumschicht abgeschieden und durch chemisch-mechanisches Polieren planarisiert. Die Speicherknoten 121 werden mit Phosphor mit einer Dotierstoffkonzentration von 10²¹ cm⁻³ in situ dotiert.

Zum Öffnen der Kontaktlöcher für die Speicherknoten 121 ist zwar eine photolithographisch erzeugte Photolackmaske erforderlich. Deren Justierung ist jedoch unkritisch, da die zweiten Wortleitungen 115 vollständig mit Siliziumnitrid bedeckt sind und die Kontaktlochätzung selektiv zu Siliziumnitrid erfolgt und somit eine Dejustage der Photolackmaske unkritisch ist.

Nachfolgend wird ein Kondensatordielektrikum 122 aus SiO₂, einer Dreifachschicht aus SiO₂, Si₃N₄ und SiO₂ oder einer ferroelektrischen Schicht aus BST (Barium-Strontium-Titanat) oder SBT (Strontium-Wismuth-Tantalat)abgeschieden. Das Kondensatordielektrikum 122 wird in einer Schichtdicke von 4 nm abgeschieden. Auf das Kondensatordielektrikum 122 wird eine Kondensatorplatte 123 aus dotiertem Polysilizium aufgebracht. Die Kondensatorplatte 123 wird durch in situ dotierte Abscheidung von Polysilizium mit Phosphor als Dotierstoff und einer Dotierstoffkonzentration von 10²¹ cm⁻³ gebildet.

In diesem Ausführungsbeispiel umfaßt jede Halbleitersäule, die durch jeweils zwei benachbarte erste Gräben 17 und zweite Gräben 110 definiert ist, zwei Speicherzellen. Diese zwei Speicherzellen weisen einen gemeinsamen ersten Auswahltransistor auf, der aus der Bitleitung 13', dem ersten n⁺-dotierten Gebiet 118 als Source-/Drain-Gebiete und dem dazwischen angeordnete Teil der ersten p-dotierten Siliziumschicht 14 als Kanalgebiet, dem ersten Gatedielektrikum 11' und der ersten Wortleitung 112' gebildet wird. Jede der Speicherzellen weist darüber hinaus einen zweiten Auswahltransistor auf, der jeweils aus dem ersten n⁺-dotierten Gebiet 118 und einem der zweiten n⁺-dotierten Gebiete 119 als Source-/Drain-Gebiete sowie dem dazwischen angeordneten Teil der zweiten p-dotierten Siliziumschicht 15 als Kanalgebiet, der zweiten dielektrischen Schicht 114 als Gatedielektrikum und der oberhalb des Kanalgebiets angeordneten zweiten Wortleitung 115 gebildet wird. Über das erste n⁺-dotierte Gebiet 118 sind die beiden zweiten Auswahltransistoren mit dem gemeinsamen ersten Auswahltransistor in Reihe verschaltet. Die oberhalb der zweiten Gräben 110 angeordneten zweiten Wortleitungen 115 haben in dieser Speicherzellenanordnung keine elektrische Funktion. Ihre Funktion besteht darin, die Kontaktlochätzung für die Speicherknoten 121 selektiv zu Siliziumnitrid zu ermöglichen.

Die Einsatzspannung des gemeinsamen ersten Auswahltransistors wird über die Dotierung der ersten p-dotierten Siliziumschicht 14 eingestellt. Die Einsatzspannung der zweiten Auswahltransistoren wird über die Dotierung der zweiten p-dotierten Siliziumschicht 15 eingestellt. Alternativ kann die Einsatzspannung der zweiten Auswahltransistoren durch eine spezielle Kanalimplantation eingestellt werden.

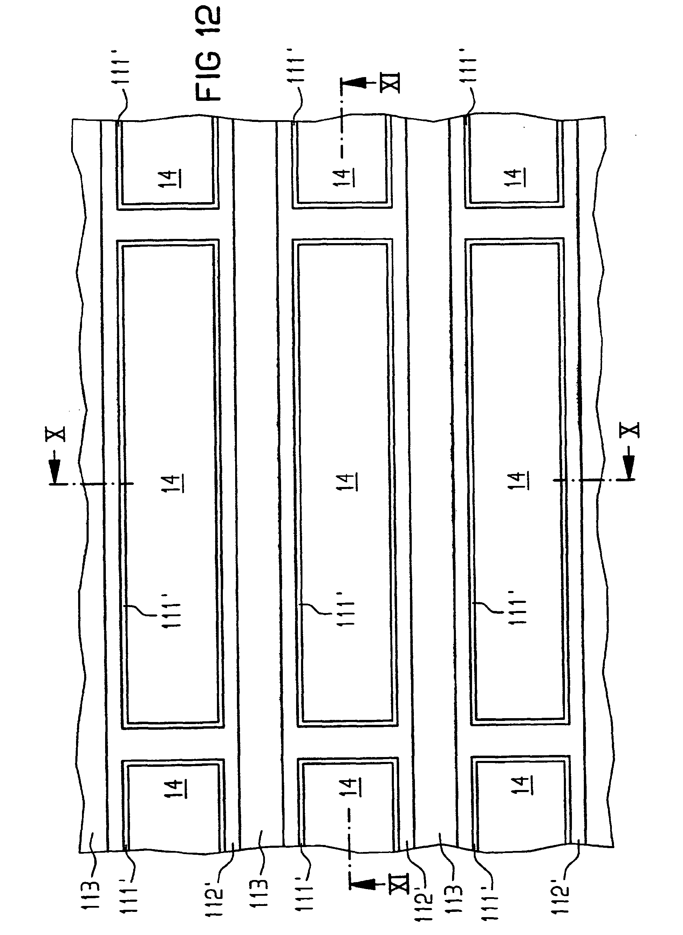

Die ersten Wortleitungen 112' verlaufen quer zu den zweiten Wortleitungen 115 und weisen ringförmige Elemente auf, die jeweils eine der Halbleitersäulen umgeben (siehe Figur 12).

Werden die ersten Gräben 17 mit einer Breite von einer minimal herstellbaren Strukturgröße F und einem Abstand von F gebildet und die zweiten Gräben 110 mit einer Breite von F abzüglich der Breite der SiO₂-Spacer 190 und einem Abstand zwischen benachbarten zweiten Gräben 110 von 5F zuzüglich der Breite der SiO₂-Spacer 190 so ergibt sich für jeweils zwei Speicherzellen ein Platzbedarf von 12F². Das heißt, die Speicherzellenanordnung ist mit einem Flächenbedarf pro Speicherzelle von 6F² herstellbar.

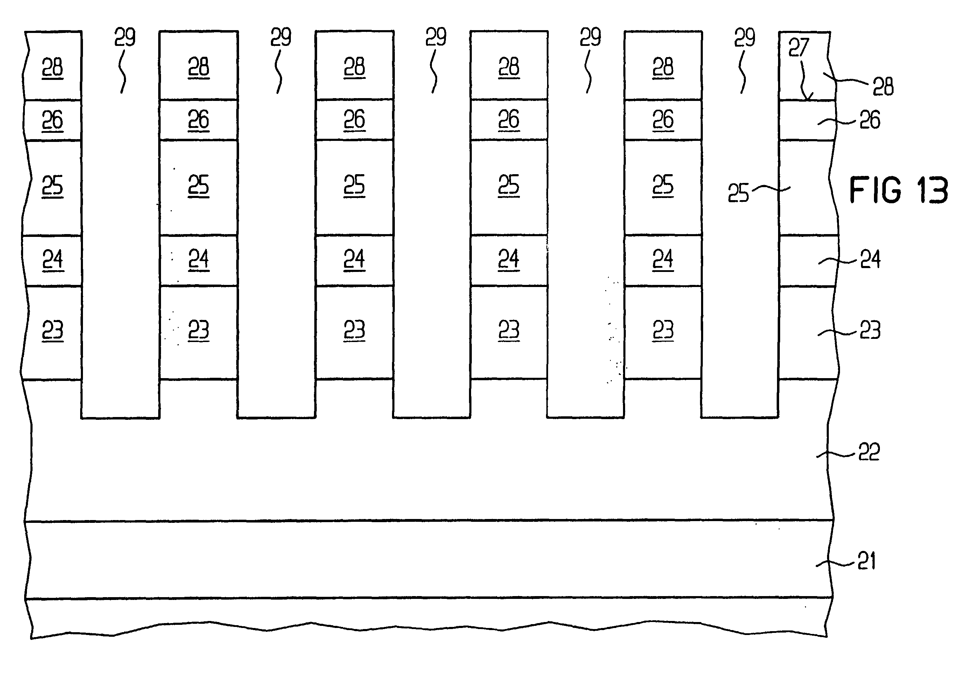

In einem Beispiel, das nützlich zum Verstehen der Erfindung ist wird ein Halbleitersubstrat verwendet, das ein SOI-Substrat 21 umfaßt, auf das eine erste n⁺-dotierte Siliziumschicht 22, eine erste p-dotierte Siliziumschicht 23, eine zweite n⁺-dotierte Siliziumschicht 24, eine zweite p-dotierte Siliziumschicht 25 und eine dritte n⁺-dotierte Schicht 26 epitaktisch aufgewachsen werden. Die dritte n⁺-dotierte Schicht 26 grenzt an eine Hauptfläche 27 an (siehe Figur 13). Die erste n⁺-dotierte Siliziumschicht 22 wird in einer Schichtdicke von 300 nm mit dem Dotierstoff As und einer Dotierstoffkonzentration von 1 x 10²⁰ cm⁻³ gebildet. Die erste p-dotierte Siliziumschicht 23 wird in einer Schichtdicke von 200 nm mit einer Dotierstoffkonzentration von 1 x 10¹⁸ cm⁻³ Bor gebildet. Die zweite n⁺-dotierte Schicht 24 wird in einer Schichtdicke von 100 nm mit einer Dotierstoffkonzentration von 1 x 10¹⁹ cm⁻³ und dem Dotierstoff As gebildet. Die zweite p-dotierte Siliziumschicht 25 wird in einer Schichtdicke von 200 nm mit einer Dotierstoffkonzentration von 1 x 10¹⁸ cm⁻³ mit Bor gebildet. Die dritte n⁺-dotierte Schicht 26 wird in einer Schichtdicke von 200 nm mit einer Dotierstoffkonzentration von 1 x 10¹⁹ cm⁻³ mit dem Dotierstoff As gebildet.

Auf der Hauptfläche 27 wird durch Abscheidung und Strukturierung einer SiO₂-Schicht eine erste Grabenmaske 28 gebildet. Die SiO₂-Schicht wird in einem TEOS-Verfahren in einer Schichtdicke von 150 nm abgeschieden. Unter Verwendung einer Photolackmaske wird sie durch anisotropes Ätzen mit CHF₃, O₂ strukturiert. Nach Entfernen der Photolackmaske werden erste Gräben 29 geätzt. Die ersten Gräben 29 werden durch anisotropes Ätzen mit HBr, He, O₂, NF₃ erzeugt. Die ersten Gräben 29 reichen bis in die erste n⁺-dotierte Siliziumschicht 22 hinein. Die ersten Gräben 29 sind streifenförmig und weisen eine Breite von 200 nm und einen Abstand zwischen benachbarten ersten Gräben 29 von 200 nm auf. Die Länge der ersten Gräben 29 beträgt 5 µm und die Tiefe 800 nm.

Nach Entfernen der ersten Grabenmaske 28 durch naßchemisches Ätzen mit HF werden an zur Hauptfläche 27 im wesentlichen senkrechten Flanken der ersten Gräben 29 Siliziumnitridspacer 210 gebildet. Dazu wird eine Siliziumnitridschicht in einer Dicke von 70 nm abgeschieden und anisotrop mit CF₄, O₂, N₂ selektiv zu Silizium geätzt. Die Dicke der Nitridschicht entspricht einem Drittel der Weite der ersten Gräben 29.

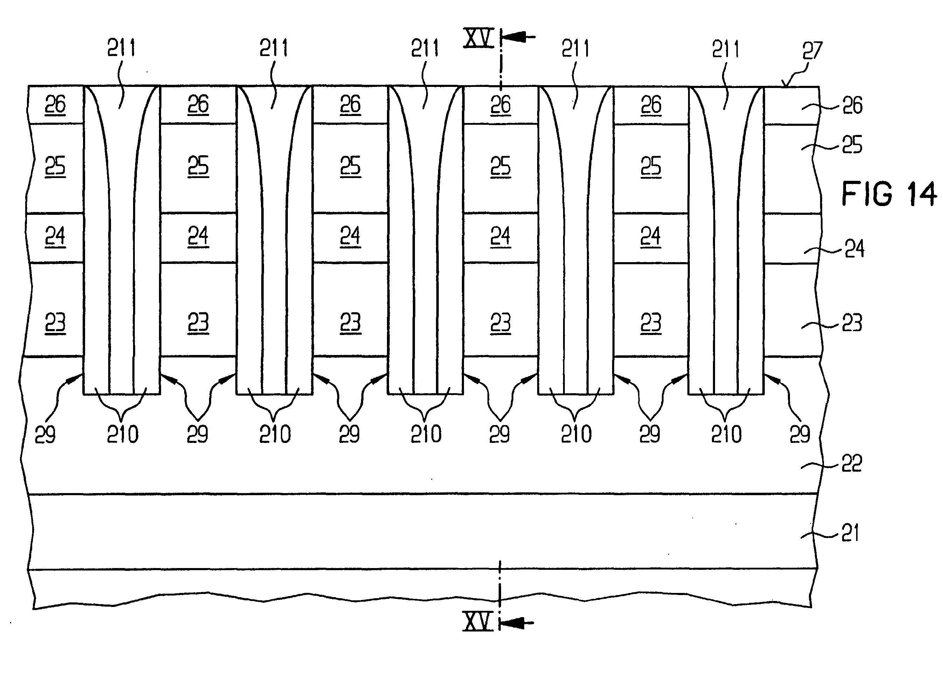

Der zwischen den Siliziumspacern 210 verbliebene Zwischenraum wird nachfolgend mit einer ersten Isolationsstruktur 211 aufgefüllt. Dazu wird eine SiO₂-Schicht in einem TEOS-Verfahren abgeschieden und anisotrop mit CHF₃, O₂ rückgeätzt, bis die Hauptfläche 27 freigelegt ist (siehe Figur 14).

Auf der Hauptfläche 27 wird eine zweite Grabenmaske durch Abscheiden einer SiO₂-Schicht und einer Siliziumnitridschicht gebildet. Die SiO₂-Schicht wird in einem TEOS-Verfahren mit einer Dicke von 150 nm abgeschieden. Die Dicke der Siliziumnitridschicht beträgt 70 nm. Unter Verwendung einer Photolackmaske wird durch anisotropes Ätzen mit CHF₃, O₂ die Nitridschicht und die SiO₂-Schicht strukturiert. Nach Entfernen der Photolackmaske werden zweite Gräben 212 erzeugt. Dabei wird zunächst Silizium anisotrop mit HBr, He, O₂, NF₃ geätzt. Nachfolgend wird SiO2 selektiv zu Nitrid mit C₂F₆, C₃F₈ geätzt, wobei die Siliziumnitridschicht der zweiten Grabenmaske als Hartmaske dient. Anschließend werden die Siliziumnitridspacer und gleichzeitig die Siliziumnitrid-Hartmaske naßchemisch mit H₃PO₄ entfernt.

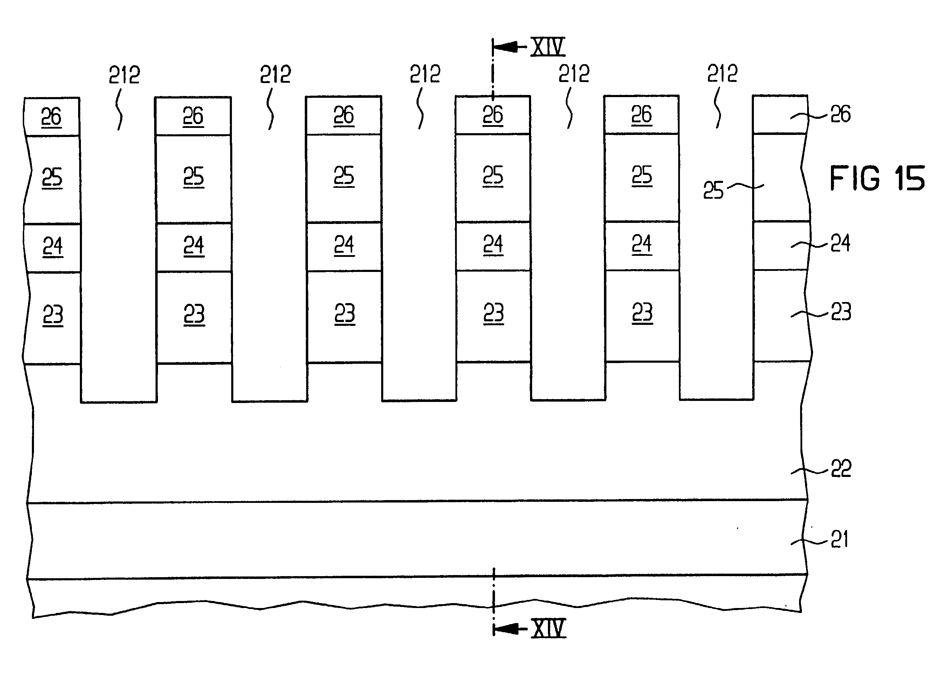

Die zweiten Gräben 212 verlaufen im wesentlichen senkrecht zu den ersten Gräben 29 (siehe Figur 15, in der der in Figur 14 mit XV-XV dargestellte Schnitt gezeigt wird). Die zweiten Gräben 212 weisen einen streifenförmigen Querschnitt auf mit einer Breite von 200 nm, einem Abstand zwischen benachbarten zweiten Gräben 212 von 200 nm und einer Länge von 5 µm. Die Tiefe der zweiten Gräben 212 beträgt 800 nm. Die zweiten Gräben 212 reichen damit ebenfalls bis in die erste n⁺-dotierte Siliziumschicht 22 hinein.

Anschließend wird die erste Isolationsstruktur 211 entfernt. Dieses erfolgt durch naßchemisches Ätzen von Siliziumoxid selektiv zu Siliziumnitrid und Silizium mit HF.

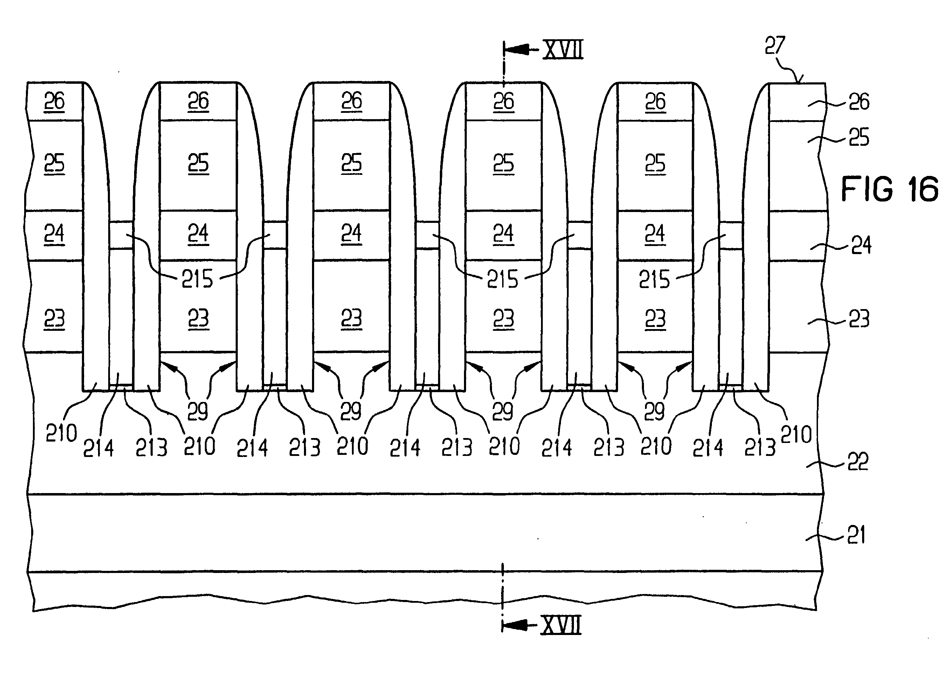

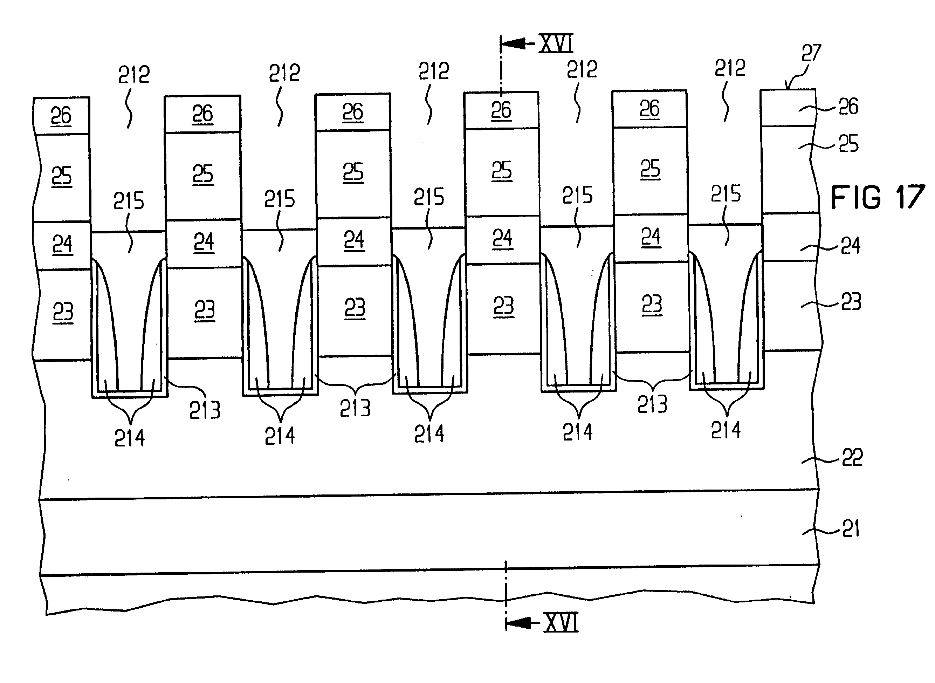

Durch thermische Oxidation wird ein erstes Gateoxid 213 in einer Dicke von 5 nm gebildet. Durch Abscheiden einer in situ dotierten Polysiliziumschicht und anisotropes Ätzen der dotierten Polysiliziumschicht werden nachfolgend erste Wortleitungen 214 gebildet. Die dotierte Polysiliziumschicht wird mit Phosphor dotiert abgeschieden. Sie weist eine Dicke von 70 nm auf. Das entspricht einem Drittel der Weite der ersten Gräben 29 sowie der zweiten Gräben 212. Damit wird der Zwischenraum zwischen den an gegenüberliegenden Flanken eines der ersten Gräben 29 angeordneten Siliziumnitridspacern 210 aufgefüllt, die zweiten Gräben 212, deren im wesentlichen senkrecht zur Hauptfläche 27 verlaufende Flanken nur mit dem dünnen ersten Gateoxid 213 bedeckt sind, jedoch nicht. Das Ätzen der dotierten Polysiliziumschicht erfolgt anisotrop mit He, HBr, Cl₂, C₂F₆. Das anisotrope Ätzen wird solange fortgesetzt, bis die Wortleitungen in der Höhe im Bereich der zweiten n⁺-dotierten Siliziumschicht 24 liegen. Die ersten Wortleitungen 214 überdecken in der Höhe die erste p-dotierte Siliziumschicht 23 vollständig (siehe Figur 16 und Figur 17).

Teile der ersten Wortleitungen 214 umgeben jeweils eine der Halbleitersäulen, die durch jeweils zwei benachbarte erste Gräben 29 und zweite Gräben 212 definiert werden, ringförmig. Der zwischen den Siliziumnitridspacern 210 verbliebene Freiraum in den ersten Gräben 29 ist dabei vollständig mit den ersten Wortleitungen 214 aufgefüllt. In den ersten Gräben 29 grenzen daher ringförmige Elemente der ersten Wortleitungen 214 zusammen. Die ersten Wortleitungen 214 werden somit gebildet durch aneinandergrenzende ringförmige Elemente.

Anschließend wird durch Abscheidung einer SiO₂-Schicht und anisotropes Rückätzen eine zweite Isolationsstruktur 215 gebildet, die in den zweiten Gräben 212 den zwischen benachbarten ersten Wortleitungen 214 verbliebenen Freiraum auffüllt. Die Höhe der zweiten Isolationsstruktur 215 ist größer als die der ersten Wortleitungen 214. Die zweite Isolationsstruktur 215 reicht maximal bis an die Grenzfläche zwischen der zweiten n⁺-dotierten Siliziumschicht 24 und der zweiten p-dotierten Siliziumschicht 25. Die Abscheidung der SiO₂-Schicht erfolgt in einem TEOS-Verfahren. Es wird anisotrop geätzt mit Ar, CF₄, CHF₃. Bei dieser anisotropen Ätzung wird auf der Hauptfläche 27 und im oberen Bereich der zweiten Gräben 212 befindliches erstes Gateoxid ebenfalls entfernt.

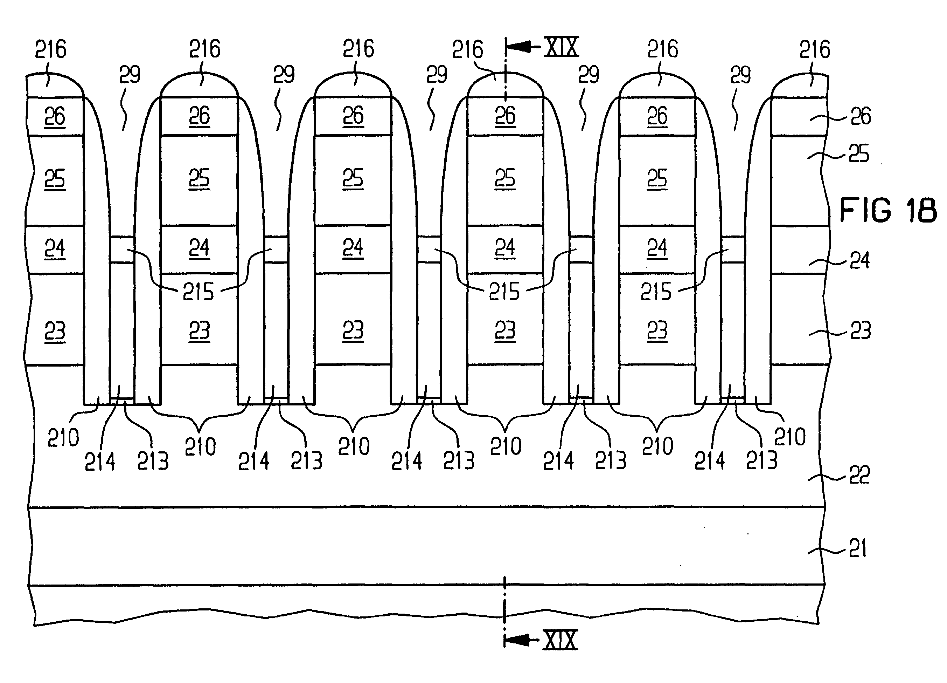

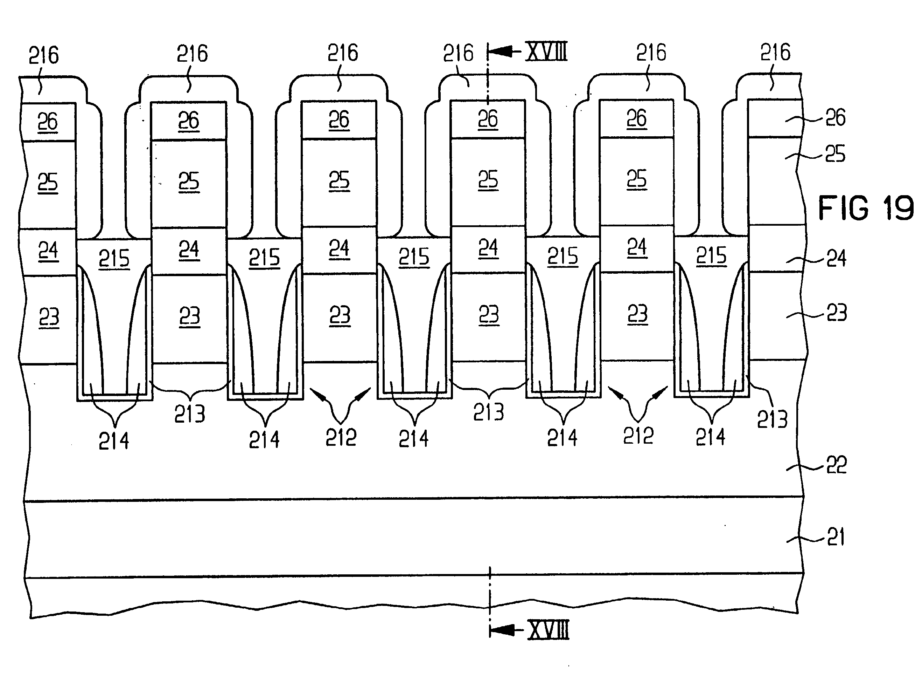

Durch selektive Epitaxie werden nachfolgend auf freiliegenden Siliziumoberflächen Siliziumstrukturen 216 aufgewachsen. Die selektive Epitaxie erfolgt im Temperaturbereich von 700°C bis 900°C unter Verwendung eines Silan enthaltenden Prozeßgases. Die Siliziumstrukturen 216 bedecken die freiliegenden Flanken im Bereich der zweiten Gräben 212 oberhalb der zweiten Isolationsstruktur 215. Ferner bedecken sie die Oberfläche der dritten n⁺-dotierten Siliziumschicht 26. Die Siliziumstrukturen 216 weisen eine Abmessung von 70 nm senkrecht zu der Siliziumoberfläche, auf der sie aufwachsen, auf. Das entspricht einem Drittel der Weite der zweiten Gräben 212. Die zweiten Gräben 212 werden daher nicht aufgefüllt. Die Flanken der ersten Gräben 29 sind durch die Siliziumnitridspacer 210 bedeckt, so daß an den Flanken der ersten Gräben 29 kein Silizium aufwächst (siehe Figur 18 und Figur 19).

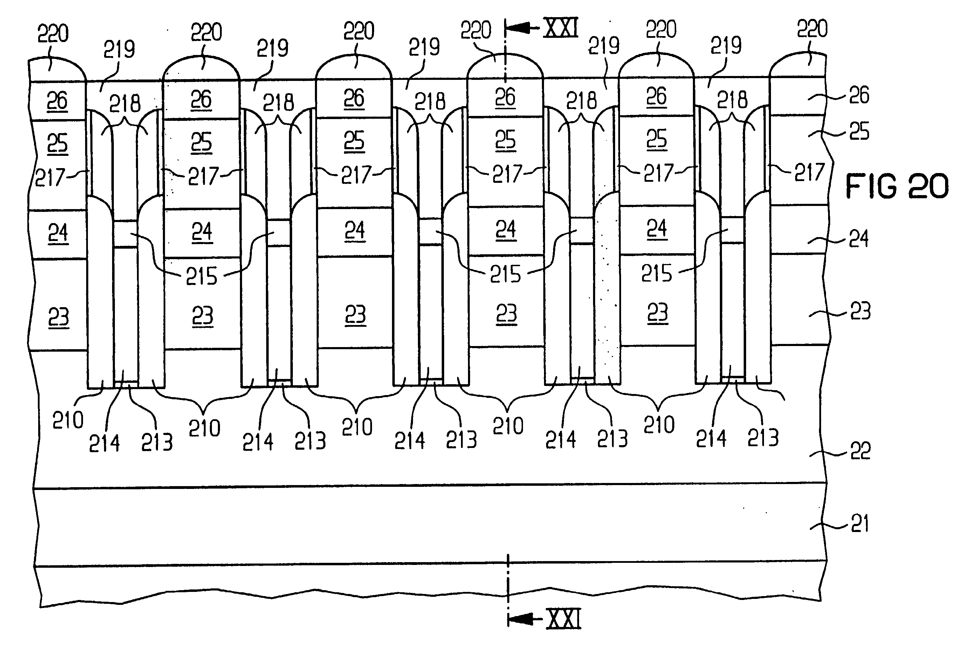

Durch naßchemisches Ätzen mit H₃PO₄ wird Siliziumnitrid selektiv zu Silizium angegriffen. Durch eine solche Ätzung werden die Flanken der dritten n⁺-dotierten Siliziumschicht 26 und der zweiten p-dotierten Siliziumschicht 25 mindestens teilweise freigelegt. Dadurch werden die Siliziumnitridspacer 210 in den ersten Gräben 29 in der Höhe reduziert (siehe Figur 20).

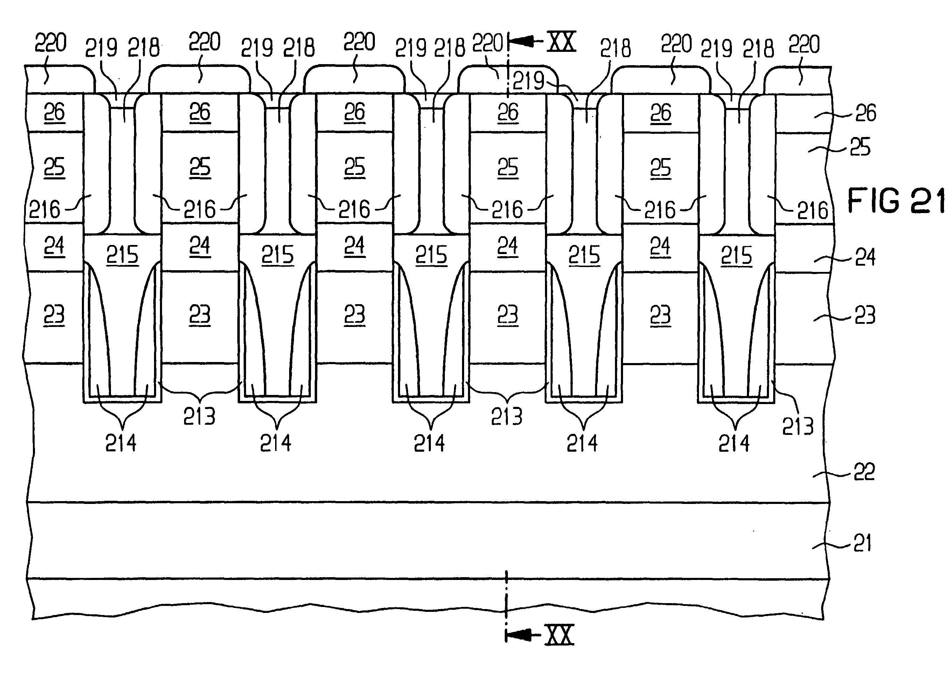

Durch thermische Oxidation wird ein zweites Gateoxid 217 an freiliegenden Siliziumflächen gebildet. Insbesondere entsteht das zweite Gateoxid 217 an der freiliegenden Oberfläche der zweiten p-dotierten Siliziumschicht 25 in den ersten Gräben 29 (siehe Figur 20 und Figur 21). Das zweite Gateoxid 217 wird in einer Schichtdicke von 5 nm gebildet.

Durch Abscheiden einer in situ dotierten Polysiliziumschicht und anisotropes Rückätzen der dotierten Polysiliziumschicht werden zweite Wortleitungen 218 gebildet. Die in situ dotierte Polysiliziumschicht wird mit Phosphor dotiert und weist eine Dotierstoffkonzentration von 10²¹ cm⁻³ auf. Die dotierte Polysiliziumschicht wird in einer Dicke von 70 nm abgeschieden. Das entspricht einem Drittel der Weite der ersten Gräben 29 sowie der zweiten Gräben 212. Das anisotrope Ätzen wird solange fortgesetzt, bis die Flanken der dritten n⁺-dotierten Siliziumschicht 26 im Bereich der ersten Gräben 29 teilweise freigelegt sind (siehe Figur 20).

Da die Weite der zweiten Gräben 212 im Bereich der Hauptfläche durch die Siliziumstrukturen 216 auf etwa ein Drittel reduziert ist, füllt die dotierte Polysiliziumschicht die zweiten Gräben 212 auf. Entsprechend füllen die zweiten Wortleitungen 218 die zweiten Gräben in der Weite auf. Die zweiten Wortleitungen 218 umfassen ringförmige Elemente, die jeweils eine der Siliziumsäulen umgeben. In den zweiten Gräben 212 stoßen benachbarte ringförmige Elemente aneinander, so daß die zweiten Wortleitungen 218 als Kette aneinander angrenzender ringförmiger Elemente gebildet werden.

Die ersten Gräben 29 werden mit einer dritten Isolationsstruktur 219 aufgefüllt. Dazu wird eine SiO₂-Schicht in einem TEOS-Verfahren abgeschieden und anisotrop mit CHF₃, O₂ geätzt. Die dritte Isolationsstruktur 219 schließt in der Höhe mit der Hauptfläche 27 ab.

Durch Implantation mit Arsen mit einer Energie von 20 keV und einer Dosis von 10¹⁴ cm⁻² werden an der Hauptfläche 27 angeordnete Speicherknoten 220 gebildet. Die Speicherknoten 220 werden aus den an der Hauptfläche 27 befindlichen Teilen der Siliziumstruktur 216 gebildet. Die Speicherknoten 219 sind mit der dritten n⁺-dotierten Siliziumschicht 26 elektrisch verbunden.

Anschließend wird ganzflächig ein Kondensatordielektrikum 221 abgeschieden. Das Kondensatordielektrikum 221 wird aus SiO₂, einer Dreifachschicht aus SiO₂, Si₃N₄ und SiO₂ oder einem Hochepsilon-Dielektrikum, zum Beispiel BST (Barium-Strontium-Titanat) oder SBT (Strontium-Wismuth-Tantalat) gebildet.

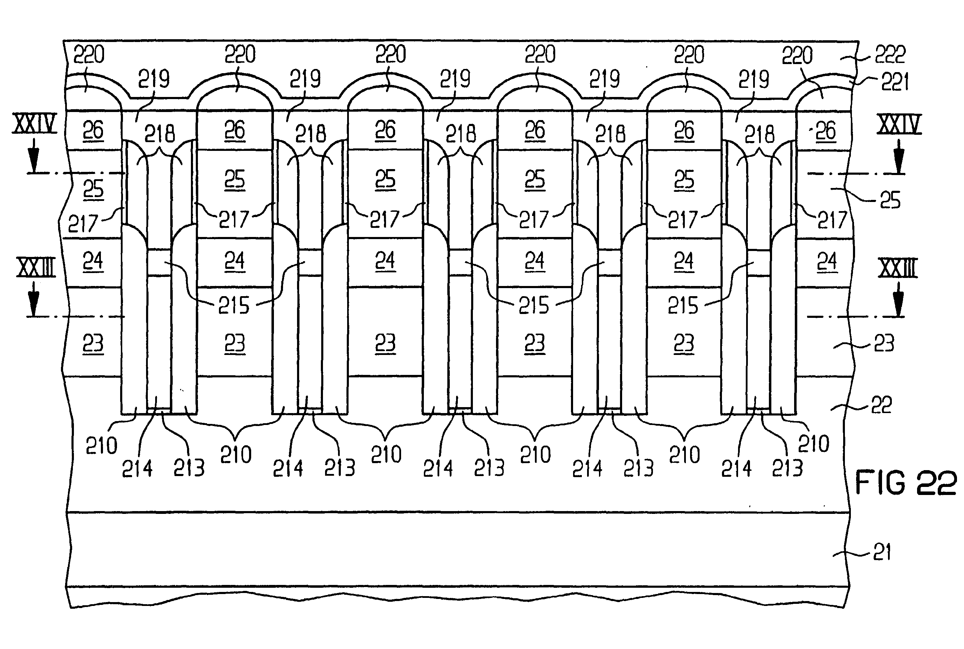

Auf das Kondensatordielektrikum 221 wird eine Kondensatorplatte 222 aufgebracht. Die Kondensatorplatte 221 wird durch in situ dotierte Abscheidung von Polysilizium in einer Schichtdicke von 200 nm und Planarisierung der dotierten Polysiliziumschicht gebildet. Die dotierte Polysiliziumschicht ist mit Phosphor mit einer Dotierstoffkonzentration von 10²¹ cm⁻³ dotiert (siehe Figur 22).

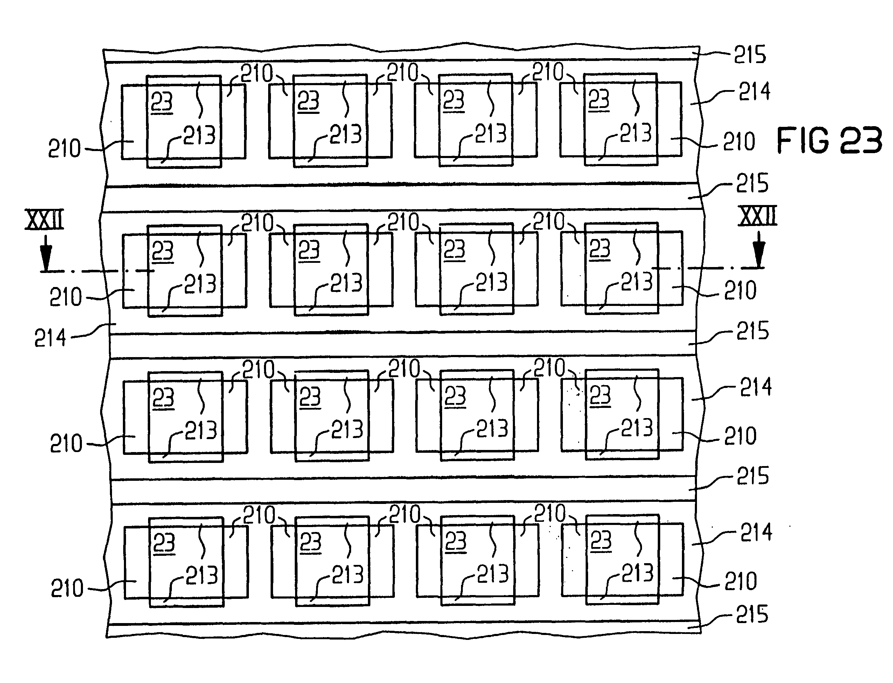

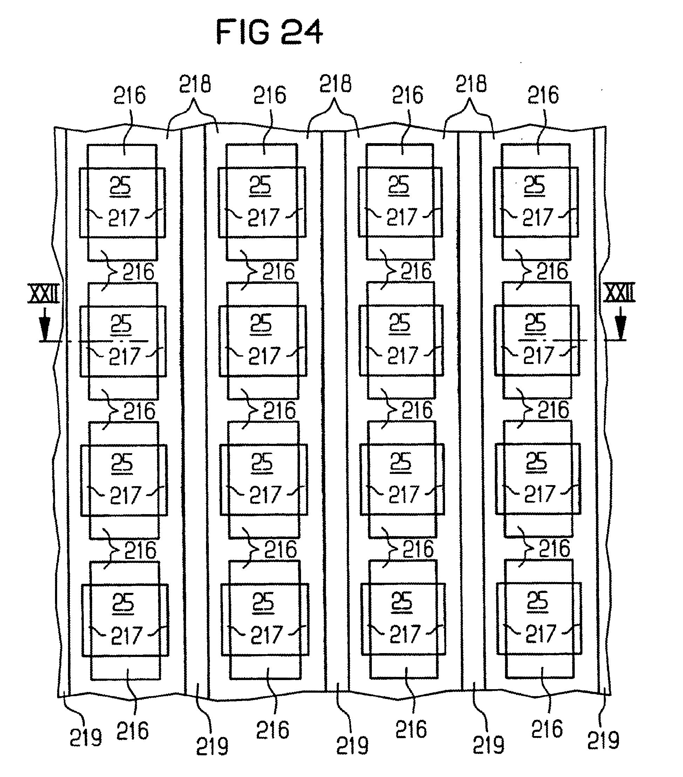

Figur 23 zeigt den in Figur 22 mit XXIII-XXIII bezeichneten Schnitt. Figur 24 zeigt den in Figur 22 mit XXIV-XXIV bezeichneten Schnitt. Die ersten Wortleitungen 214 und die zweiten Wortleitungen 218 sind jeweils als Kette ringförmiger Elemente ausgebildet und verlaufen untereinander jeweils parallel. Die ersten Wortleitungen 214 und die zweiten Wortleitungen 218 verlaufen quer zueinander.

In dieser Form der Speicherzellenanordnung umfaßt jede Halbleitersäule, die jeweils durch zwei benachbarte erste Gräben 29 und zweite Gräben 212 definiert wird, eine Speicherzelle. Die Speicherzelle weist einen ersten Auswahltransistor auf, der aus der ersten n⁺-dotierten Siliziumschicht 22 und der zweiten n⁺-dotierten Siliziumschicht 24 als Source-/Drain-Gebiete, der ersten p-dotierten Siliziumschicht 23 als Kanalbereich, dem ersten Gateoxid 213 und der ersten Wortleitung 214 als Gateelektrode gebildet wird. Ein zweiter Auswahltransistor der Speicherzelle wird aus der zweiten n⁺-dotierten Siliziumschicht 24 und der dritten n⁺- dotierten Siliziumschicht 26 als Source-/Drain-Gebiet, der zweiten p-dotierten Siliziumschicht 25 als Kanalbereich, dem zweiten Gateoxid 217 und der zweiten Wortleitung 218 als Gateelektrode gebildet. Der erste Auswahltransistor und der zweite Auswahltransistor sind über die zweite n⁺-dotierte Siliziumschicht 24, die als gemeinsames Source-/Drain-Gebiet wirkt, in Reihe verschaltet. Die erste n⁺-dotierte Siliziumschicht 22 wirkt als gemeinsame Bitleitung.

Bei einem weiteren Beispiel, das nützlich zum Verstehen der Erfindung ist wird die zweite n⁺-dotierte Siliziumschicht 24 durch eine p-dotierte Siliziumschicht ersetzt. In diesem Fall umfaßt jede Speicherzelle nur einen Auswahltransistor, der jedoch über zwei Gateelektroden angesteuert wird, die übereinander angeordnet sind und deren Streufelder so groß sind, daß sie sich überlappen. Die überlappenden Streufelder führen im eingeschalteten Zustand dazu, daß sich ein leitender Kanal von der ersten n⁺- dotierten Siliziumschicht 22 zur dritten n⁺-dotierten Siliziumschicht 26 durch alle p-dotierten Siliziumschichten hindurch ausbildet. Der Auswahltransistor wirkt wie zwei in Reihe verschaltete Auswahltransistoren, da sich ein leitender Kanal nur bei Ansteuerung beider Gateelektroden ausbildet.

Zum Einschreiben einer Information in einer Speicherzellenanordnung mit ersten Wortleitungen WLXi, i = 1 bis n, und zweiten Wortleitungen WLYi, i = 1 bis n, und einer gemeinsamen Bitleitungsplatte BLP wird ein Datenwort über eine Datenleitung DL in ein erstes Schieberegister SR1 eingelesen. Parallel dazu wird das Datenwort über einen Inverter I invertiert und in ein zweites Schieberegister SR2 eingelesen. Die Ausgänge des ersten Schieberegisters SR1 sind über einen Schalter S1 mit den ersten Wortleitungen WLXi, i = 1 bis n, verbunden. Die Ausgänge des zweiten Schieberegisters sind über einen Schalter S0 mit den ersten Wortleitungen WLXi, i =1 bis n, verbunden.

Zum Einschreiben einer Information mit dem logischen Wert Eins wird der Schalter S1 so angesteuert, daß die Ausgänge des ersten Schieberegisters SR1 mit den ersten Wortleitungen WLXi, i = 1 bis n, verbunden sind. Die Bitleitungsplatte BLP wird mit einem Spannungswert beaufschlagt, der einer logischen Eins entspricht. Über die ersten Wortleitungen WLXi, i = 1 bis n, und die zweite Wortleitung WLYi, i = 1, werden die einzelnen Speicherzellen angesteuert, in denen eine logische Eins gespeichert wird. Auf diese Weise werden ohne Umladung der Bitleitungsplatte BLP alle Speicherzellen entlang der zweiten Wortleitung WLYi, i = 1, mit einer Eins beschrieben, in denen eine Eins gespeichert werden soll.

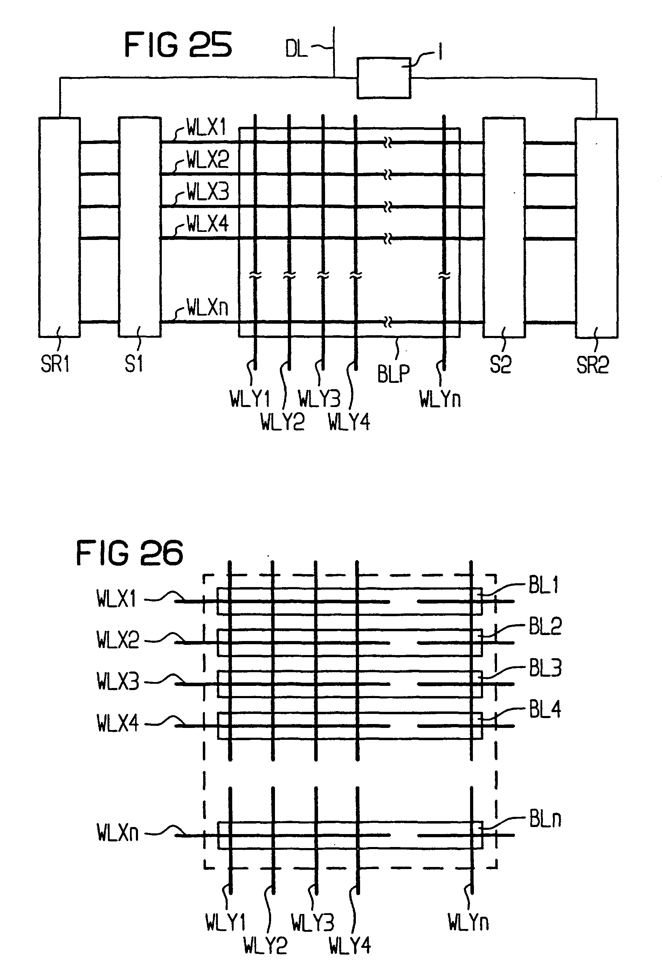

Anschließend wird die Verbindung zwischen den ersten Wortleitungen WLXi, i = 1 bis n, und dem ersten Schieberegister SR1 durch entsprechende Ansteuerung des Schalters S1 getrennt und die Bitleitungsplatte BLP mit einem Spannungspegel beaufschlagt, der einer logischen Null entspricht. Nachfolgend wird der Schalter S0 so angesteuert, daß das zweite Schieberegister mit den ersten Wortleitungen WLXi, i = 1 bis n, verbunden ist. Nachfolgend werden über die ersten Wortleitungen WLXi, i = 1 bis n, und die zweiten Wortleitungen WLYi, i = 1, die einzelnen Speicherzellen angesteuert, in denen eine logische Null gespeichert werden soll. Das nächste Datenwort wird entsprechend eingelesen, wobei jetzt die zweite Wortleitung WLYi, i = 2, eingeschaltet wird. Für das Einlesen der folgenden Datenwörter wird der Laufindex i der zweiten Wortleitung WLYi weiter inkrementiert (siehe Figur 25).

Zum Auslesen einer Speicherzellenanordnung mit ersten Wortleitungen WLXi, i = 1 bis n, und zweiten Wortleitungen WLYi, i = 1 bis n, und streifenförmigen Bitleitungen BLi, i = 1 bis n, werden die einzelnen Speicherzellen, die entlang einer streifenförmigen Bitleitung BLi angeordnet sind, nacheinander über die zugehörige erste Wortleitung WLXi und die zugehörigen zweiten Wortleitungen WLYi, i = 1 bis n, angesteuert (siehe Figur 26). Das Auslesen der Daten erfolgt parallel für alle Bitleitungen BLi, i = 1 bis n. Dieses parallele Auslesen erfolgt innerhalb eines Zellenblockes ZB. Zusätzlich dazu können mehrere Zellenblöcke definiert werden, die darüber hinaus parallel ausgelesen werden. Dadurch wird die Zeit für den Datenzugriff verkürzt.

Zum Refresh von Daten in einer DRAM-Zellenanordnung werden zunächst die gespeicherten Informationen, wie anhand von Figur 26 geschildert, ausgelesen in ein Schieberegister und anschließend, wie anhand von Figur 25 geschildert, wieder eingelesen. Der Vorteil dieses Betriebsverfahrens liegt darin, daß die gespeicherte Information, die ausgelesen wird, nur zur Ansteuerung einer Wortleitung und nicht zum Anheben des zugehörigen Pegels in der Speicherzelle verwendet wird.

## Patentansprüche

1. Speicherzellenanordnung,
- bei der ein Halbleitersubstrat mit einer Vielzahl von Speicherzellen vorgesehen ist,
- bei der die Speicherzellen jeweils über eine erste Wortleitung (112') und eine zweite Wortleitung (115) ansteuerbar sind und sich die erste Wortleitung (112') und die zweite Wortleitung (115) kreuzen,
- bei der die Speicherzellen jeweils einen ersten Auswahltransistor und einen zweiten Auswahltransistor aufweisen, die in Reihe geschaltet sind, der erste Auswahltransistor von der ersten Wortleitung und der zweite Auswahltransistor von der zweiten Wortleitung ansteuerbar ist und mindestes einer der beiden Auswahltransistoren in Bezug auf eine Hauptfläche des Halbleitersubstrats ein vertikaler Auswahltransistor ist, der mit einem Speicherelement (121, 122, 123) verbunden ist, und
- bei der zwei benachbarte Speicherzellen einen gemeinsamen ersten Auswahltransistor und eine gemeinsame erste Wortleitung, jedoch unterschiedliche zweite Auswahltransistoren und zweite Wortleitungen aufweisen.

2. Speicherzellenanordnung nach Anspruch 1,
- bei der jeweils mehrere der Speicherzellen zu einem Zellenblock zusammengefaßt sind,
- bei der die Speicherzellen jedes Zellenblocks mit einer gemeinsamen Bitleitung (22) verbunden sind.

3. Speicherzellenanordnung nach Anspruch 1 oder 2,
- bei der der erste Auswahltransistor als in Bezug auf die Hauptfläche (11) des Halbleitersubstrats vertikaler Transistor ausgestaltet ist und
- bei der der erste Auswahltransistor und der zweite Auswahltransistor übereinander angeordnet sind.

4. Speicherzellenanordnung nach Anspruch 3, bei der der zweite Auswahltransistor als in Bezug auf die Hauptfläche (27) des Halbleitersubstrats vertikaler Transistor ausgestaltet ist.

5. Speicherzellenanordnung nach Anspruch 3 oder 4,
- bei der das Halbleitersubstrat Halbleitersäulen aufweist, die an die Hauptfläche (11) angrenzen und deren Flanken die Hauptfläche (11) kreuzen,
- bei der jeweils einer der Auswahltransistoren der Speicherzellen als MOS-Transistor ausgestaltet ist und an mindestens einer Flanke einer der Halbleitersäulen angeordnet ist.

6. Speicherzellenanordnung nach Anspruch 4,
- bei der das Halbleitersubstrat Halbleitersäulen aufweist, die an die Hauptfläche angrenzen und deren Flanken die Hauptfläche kreuzen und die rasterförmig angeordnet sind,
- bei der der erste Auswahltransistor und der zweite Auswahltransistor einer Speicherzelle jeweils entlang mindestens einer Flanke einer der Halbleitersäulen angeordnet sind,
- bei der die erste Wortleitung (214) ringförmige Elemente aufweist, die benachbarte Halbleitersäulen umgeben und die miteinander verbunden sind,
- bei der die zweite Wortleitung (218), die quer zur ersten Wortleitung (214) verläuft, ringförmige Elemente aufweist, die benachbarte Halbleitersäulen umgeben und die miteinander verbunden sind.

7. Speicherzellenanordnung nach einem der Ansprüche 1 bis 6, bei der als Speicherelement eine Speicherkapazität vorgesehen ist.

8. Speicherzellenanordnung nach Anspruch 7,
- bei der Bitleitungen als im Halbleitersubstrat vergrabene Bitleitungen realisiert sind,
- bei der die Speicherkapazität an und/oder oberhalb der Hauptfläche des Halbleitersubstrats angeordnet ist.

9. Verfahren zur Herstellung einer Speicherzellenanordnung, bei dem Speicherzellen gebildet werden, die
- jeweils über eine erste Wortleitung und eine zweite Wortleitung ansteuerbar sind, die sich kreuzen,
- die jeweils einen in Reihe geschalteten ersten und zweiten Auswahltransistor aufweisen, wobei der erste Auswahltransistor von der ersten Wortleitung und der zweite Auswahltransistor von der zweiten Wortleitung ansteuerbar ist und mindestes einer der beiden Auswahltransistoren ein vertikaler Auswahltransistor ist, der mit einem Speicherelement (121, 122, 123) verbunden ist, und
- zwei benachbarte Speicherzellen einen gemeinsamen ersten Auswahltransistor und eine gemeinsame erste Wortleitung, jedoch unterschiedliche zweite Auswahltransistoren und zweite Wortleitungen aufweisen.

10. Verfahren nach Anspruch 9,
- bei dem in eine Hauptfläche eines Halbleitersubstrats erste Gräben und zweite Gräben geätzt werden, wobei die ersten Gräben die zweiten Gräben kreuzen, so daß Halbleitersäulen entstehen, die die Hauptfläche kreuzende Flanken aufweisen,
- bei dem der erste Auswahltransistor und der zweite Auswahltransistor einer Speicherzelle jeweils übereinander an mindestens einer Flanke einer der Halbleitersäulen gebildet werden, wobei der erste Auswahltransistor mit einer ersten Gateelektrode und der zweite Auswahltransistor mit einer zweiten Gateelektrode versehen wird und die erste Gateelektrode mit der ersten Wortleitung und die zweite Gateelektrode mit der zweiten Wortleitung verbunden wird.

11. Verfahren nach Anspruch 10,
- bei dem im Bereich der ersten Gateelektroden jeweils an mindestens einer Flanke der Halbleitersäule eine erste Hilfsstruktur erzeugt wird, so daß der Abstand benachbarter Halbleitersäulen in Richtung der ersten Gräben größer als in Richtung der zweiten Gräben ist,
- bei dem die ersten Gateelektroden ringförmig gebildet werden, wobei die ersten Gateleketorden die jeweilige Halbleitersäule umgeben, wobei die ersten Gateelektroden von in Richtung der zweiten Gräben benachbarten Speicherzellen aneinander grenzen und Teile der ersten Wortleitung bilden,
- bei dem im Bereich der zweiten Gateelektroden jeweils an mindestens einer Flanke der Halbleitersäule eine zweite Hilfsstruktur erzeugt wird, so daß der Abstand benachbarter Halbleitersäulen in Richtung der zweiten Gräben größer als in Richtung der ersten Gräben ist,
- bei dem die zweiten Gateelektroden ringförmig gebildet werden, wobei die zweiten Gateelektroden die jeweilige Halbleitersäule umgeben, wobei die zweiten Gateelektroden von in Richtung der ersten Gräben benachbarten Speicherzellen aneinandergrenzen und Teile der zweiten Wortleitungen bilden.

12. Verfahren nach Anspruch 11,
bei dem die ersten Hilfsstrukturen und/oder die zweiten Hilfsstrukturen durch konformes Abscheiden und anisotropes Ätzen und/oder durch selektive Epitaxie gebildet werden.

13. Verfahren nach Anspruch 9,
- bei dem in einer Hauptfläche eines Halbleitersubstrats erste Gräben und zweite Gräben geätzt werden, wobei die ersten Gräben die zweiten Gräben kreuzen, so daß Halbleitersäulen entstehen, die die Hauptfläche kreuzende Flanken aufweisen,
- bei dem der erste Auswahltransistor einer Speicherzelle jeweils an mindestens einer Flanke einer der Halbleitersäulen und der zweite Auswahltransistor der Speicherzelle im Bereich der Hauptfläche gebildet wird.

14. Verfahren nach einem der Ansprüche 9 bis 13,
- bei dem in dem Halbleitersubstrat eine vergrabene dotierte Schicht gebildet wird,
- bei dem die Tiefe der ersten Gräben so bemessen wird, daß aus der vergrabenen dotierten Schicht vergrabene Bitleitungen in Form von streifenförmigen, dotierten Gebieten gebildet werden,
- bei dem die Tiefe der zweiten Gräben geringer als die der ersten Gräben ist.

## Claims

1. Memory cell arrangement,
- in which a semiconductor substrate having a multiplicity of memory cells is provided,
- in which the memory cells can each be driven via a first word line (112') and a second word line (115) and the first word line (112') and the second word line (115) cross one another,
- in which the memory cells each have a first selection transistor and a second selection transistor, which are connected in series, the first selection transistor can be driven by the first word line and the second selection transistor can be driven by the second word line, and at least one of the two selection transistors is a vertical selection transistor with respect to a main area of the semiconductor substrate, said vertical selection transistor being connected to a storage element (121, 122, 123), and
- in which two adjacent memory cells have a common first selection transistor and a common first word line, but different second selection transistors and second word lines.

2. Memory cell arrangement according to Claim 1,
- in which a plurality of the memory cells are in each case combined to form a cell block,
- in which the memory cells of each cell block are connected to a common bit line (22).

3. Memory cell arrangement according to Claim 1 or 2,
- in which the first selection transistor is configured as a vertical transistor with respect to the main area (11) of the semiconductor substrate, and
- in which the first selection transistor and the second selection transistor are arranged one above the other.

4. Memory cell arrangement according to Claim 3, in which the second selection transistor is configured as a vertical transistor with respect to the main area (27) of the semiconductor substrate.

5. Memory cell arrangement according to Claim 3 or 4,
- in which the semiconductor substrate has semiconductor pillars which adjoin the main area (11) and whose sidewalls cross the main area (11),
- in which in each case one of the selection transistors of the memory cells is configured as a MOS transistor and is arranged on at least one sidewall of one of the semiconductor pillars.

6. Memory cell arrangement according to Claim 4,
- in which the semiconductor substrate has semiconductor pillars which adjoin the main area and whose sidewalls cross the main area and are arranged in the form of a grid,
- in which the first selection transistor and the second selection transistor of a memory cell are in each case arranged along at least one sidewall of one of the semiconductor pillars,
- in which the first word line (214) has annular elements which surround adjacent semiconductor pillars and which are connected to one another,
- in which the second word line (218), which runs transversely with respect to the first word line (214), has annular elements which surround adjacent semiconductor pillars and which are connected to one another.

7. Memory cell arrangement according to one of Claims 1 to 6,
in which a storage capacitance is provided as the storage element.

8. Memory cell arrangement according to Claim 7,
- in which bit lines are realized as bit lines buried in the semiconductor substrate,
- in which the storage capacitance is arranged on and/or above the main area of the semiconductor substrate.

9. Method for fabricating a memory cell arrangement, in which memory cells are formed which
- can each be driven via a first word line and a second word line, which cross one another,
- each have a first and second selection transistor connected in series, in which case the first selection transistor can be driven by the first word line and the second selection transistor can be driven by the second word line and at least one of the two selection transistors is a vertical selection transistor connected to a storage element (121, 122, 123), and
- two adjacent memory cells have a common first selection transistor and a common first word line, but different second selection transistors and second word lines.

10. Method according to Claim 9,
- in which first trenches and second trenches are etched into a main area of a semiconductor substrate, the first trenches crossing the second trenches, thereby giving rise to semiconductor pillars which have sidewalls crossing the main area,
- in which the first selection transistor and the second selection transistor of a memory cell are formed, in each case one above the other, on at least one sidewall of one of the semiconductor pillars, the first selection transistor being provided with a first gate electrode and the second selection transistor being provided with a second gate electrode and the first gate electrode being connected to the first word line and the second gate electrode being connected to the second word line.

11. Method according to Claim 10,
- in which a first auxiliary structure is produced in the region of the first gate electrodes in each case on at least one sidewall of the semiconductor pillar, with the result that the distance between adjacent semiconductor pillars in the direction of the first trenches is greater than in the direction of the second trenches,
- in which the first gate electrodes are formed annularly, the first gate electrodes surrounding the respective semiconductor pillar, the first gate electrodes of adjacent memory cells in the direction of the second trenches adjoining one another and forming parts of the first word line,
- in which a second auxiliary structure is produced in the region of the second gate electrodes in each case on at least one sidewall of the semiconductor pillar, with the result that the distance between adjacent semiconductor pillars in the direction of the second trenches is greater than in the direction of the first trenches,
- in which the second gate electrodes are formed annularly, the second gate electrodes surrounding the respective semiconductor pillar, the second gate electrodes of adjacent memory cells in the direction of the first trenches adjoining one another and forming parts of the second word lines.

12. Method according to Claim 11,
in which the first auxiliary structures and/or the second auxiliary structures are formed by conformal deposition and anisotropic etching and/or by selective epitaxy.

13. Method according to Claim 9,
- in which first trenches and second trenches are etched in a main area of a semiconductor substrate, the first trenches crossing the second trenches, thereby giving rise to semiconductor pillars which have sidewalls crossing the main area,
- in which the first selection transistor of a memory cell is in each case formed on at least one sidewall of one of the semiconductor pillars and the second selection transistor of the memory cell is formed in the region of the main area.

14. Method according to one of Claims 9 to 13,
- in which a buried doped layer is formed in the semiconductor substrate,
- in which the depth of the first trenches is dimensioned in such a way that buried bit lines in the form of doped regions in strip form are formed from the buried doped layer,
- in which the depth of the second trenches is less than that of the first trenches.

## Revendications

1. Ensemble de cellules de mémoire,
- dans lequel il est prévu un substrat semi-conducteur avec de nombreuses cellules de mémoire,
- dans lequel les cellules de mémoire sont commandables à chaque fois par l'intermédiaire d'une première ligne de mot (112') et d'une deuxième ligne de mot (115) et la première ligne de mot (112') et la deuxième ligne de mot (115) se croisent,
- dans lequel les cellules de mémoire comportent à chaque fois un premier transistor de sélection et un deuxième transistor de sélection qui sont branchés en série, le premier transistor de sélection est commandable par la première ligne de mot et le deuxième transistor de sélection par la deuxième ligne de mot et au moins l'un des deux transistors de sélection est par rapport à une surface principale du substrat semi-conducteur un transistor de sélection vertical qui est relié à un élément de mémoire (121, 122, 123), et
- dans lequel deux cellules de mémoire voisines comportent un premier transistor de sélection commun et une première ligne de mot commune mais des deuxièmes transistors de sélection différents et des deuxièmes lignes de mot différentes.

2. Ensemble de cellules de mémoire selon la revendication 1,
- dans lequel, à chaque fois, plusieurs cellules de mémoire sont réunies en un bloc de cellules,
- dans lequel les cellules de mémoire de chaque bloc de cellules sont reliées à une ligne de bit commune (22).

3. Ensemble de cellules de mémoire selon la revendication 1 ou 2,
- dans lequel le premier transistor de sélection est conçu comme un transistor vertical par rapport à la surface principale (11) du substrat semi-conducteur, et
- dans lequel le premier transistor de sélection et le deuxième transistor de sélection sont agencés l'un au-dessus de l'autre.

4. Ensemble de cellules de mémoire selon la revendication 3,
dans lequel le deuxième transistor de sélection est conçu comme un transistor vertical par rapport à la surface principale (27) du substrat semi-conducteur.

5. Ensemble de cellules de mémoire selon la revendication 3 ou 4,
- dans lequel le substrat semi-conducteur comporte des colonnes semi-conductrices qui sont adjacentes à la surface principale (11) et dont les flancs croisent la surface principale (11),
- dans lequel, à chaque fois, l'un des transistors de sélection des cellules de mémoire est conçu comme un transistor MOS et est agencé sur au moins un flanc de l'une des colonnes semi-conductrices.

6. Ensemble de cellules de mémoire selon la revendication 4,
- dans lequel le substrat semi-conducteur comporte des colonnes semi-conductrices qui sont adjacentes à la surface principale, dont les flancs croisent la surface principale, et qui sont agencées en forme de grille,
- dans lequel le premier transistor de sélection et le deuxième transistor de sélection d'une cellule de mémoire sont agencés à chaque fois le long d'au moins un flanc de l'une des colonnes semi-conductrices,
- dans lequel la première ligne de mot (214) comporte des éléments annulaires qui entourent des colonnes semi-conductrices voisines et qui sont reliés entre eux,
- dans lequel la deuxième ligne de mot (218) qui s'étend transversalement par rapport à la première ligne de mot (214) comporte des éléments annulaires qui entourent des colonnes semi-conductrices voisines et qui sont reliés entre eux.

7. Ensemble de cellules de mémoire selon l'une des revendications 1 à 6,
dans lequel il est prévu une capacité de stockage comme élément de mémoire.

8. Ensemble de cellules de mémoire selon la revendication 7,
- dans lequel des lignes de bit sont réalisées comme des lignes de bit enfouies dans le substrat semi-conducteur,
- dans lequel la capacité de stockage est agencée sur et/ou au-dessus de la surface principale du substrat semi-conducteur.

9. Procédé de fabrication d'un ensemble de cellules de mémoire, dans lequel on forme des cellules de mémoire
- qui sont commandables à chaque fois par l'intermédiaire d'une première ligne de mot et d'une deuxième ligne de mot qui se croisent,
- qui comportent à chaque fois un premier et un deuxième transistor de sélection qui sont branchés en série, le premier transistor de sélection étant commandable par la première ligne de mot et le deuxième transistor de sélection par la deuxième ligne de mot et au moins l'un des deux transistors de sélection étant un transistor de sélection vertical qui est relié à un élément de mémoire (121, 122, 123), et
- deux cellules de mémoire voisines comportant un premier transistor de sélection commun et une première ligne de mot commune mais des deuxièmes transistors de sélection différents et des deuxièmes lignes de mot différentes.

10. Procédé selon la revendication 9,
- dans lequel on grave des premières tranchées et des deuxièmes tranchées dans une surface principale, les premières tranchées croisant les deuxièmes tranchées, de telle sorte qu'il se forme des colonnes semi-conductrices qui ont des flancs qui croisent la surface principale,
- dans lequel on forme le premier transistor de sélection et le deuxième transistor de sélection d'une cellule de mémoire à chaque fois l'un au-dessus de l'autre sur au moins un flanc de l'une des colonnes semi-conductrices, le premier transistor de sélection étant muni d'une première électrode de grille et le deuxième transistor de sélection d'une deuxième électrode de grille et la première électrode de grille étant reliée à la première ligne de mot et la deuxième électrode de grille à la deuxième ligne de mot.

11. Procédé selon la revendication 10,
- dans lequel on produit une première structure auxiliaire dans la zone des premières électrodes de grille à chaque fois sur au moins un flanc de la colonne semi-conductrice de telle sorte que l'écartement de colonnes semi-conductrices voisines dans la direction des premières tranchées est supérieur à celui dans la direction des deuxièmes tranchées,
- dans lequel on forme les premières électrodes de grille en anneau, les premières électrodes de grille entourant la colonne semi-conductrice respective, les premières électrodes de grille de cellules de mémoire voisines dans la direction des deuxièmes tranchées étant adjacentes et formant des parties de la première ligne de mot,
- dans lequel on produit une deuxième structure auxiliaire dans la zone des deuxièmes électrodes de grille à chaque fois sur au moins un flanc de la colonne semi-conductrice de telle sorte que l'écartement de colonnes semi-conductrices voisines dans la direction des deuxièmes tranchées est supérieur à celui dans la direction des premières tranchées,
- dans lequel on forme les deuxièmes électrodes de grille en anneau, les deuxièmes électrodes de grille entourant la colonne semi-conductrice respective, les deuxièmes électrodes de grille de cellules de mémoire voisines dans la direction des premières tranchées étant adjacentes et formant des parties des deuxièmes lignes de mot.

12. Procédé selon la revendication 11,
dans lequel on forme les premières structures auxiliaires et/ou les deuxièmes structures auxiliaires par dépôt conforme et gravure anisotrope et/ou par épitaxie sélective.

13. Procédé selon la revendication 9,
- dans lequel on grave des premières et des deuxièmes tranchées dans une surface principale d'un substrat semi-conducteur, les premières tranchées croisant les deuxièmes tranchées, de telle sorte qu'il se forme des colonnes semi-conductrices qui ont des flancs qui croisent la surface principale,
- dans lequel on forme le premier transistor de sélection d'une cellule de mémoire à chaque fois sur au moins un flanc de l'une des colonnes semi-conductrices et le deuxième transistor de sélection de la cellule de mémoire dans la zone de la surface principale.

14. Procédé selon l'une des revendications 9 à 13,
- dans lequel on forme une couche dopée enfouie dans le substrat semi-conducteur,
- dans lequel on dimensionne la profondeur des premières tranchées de telle sorte que des lignes de bit enfouies sont formées sous forme de régions dopées en forme de bandes à partir de la couche dopée enfouie,
- dans lequel la profondeur des deuxièmes tranchées est inférieure à celle des premières tranchées.
